(19) Europäisches Patentamt
European Patent Office
Office européen des brevets

(11) EP 3 406 645 B1

(12) **EUROPEAN PATENT SPECIFICATION**

(45) Date of publication and mention of the grant of the patent:
**30.09.2020 Bulletin 2020/40**

(21) Application number: **17741445.5**

(22) Date of filing: **18.01.2017**

(51) Int Cl.:
***C08G 59/42*** *(2006.01)* ***C09D 163/00*** *(2006.01)*
***C09J 11/06*** *(2006.01)* ***C09J 163/00*** *(2006.01)*
***H01L 23/29*** *(2006.01)* ***H01L 23/31*** *(2006.01)*
***C08G 59/24*** *(2006.01)* ***C08G 59/32*** *(2006.01)*
***C08G 59/68*** *(2006.01)*

(86) International application number:
**PCT/JP2017/001600**

(87) International publication number:
**WO 2017/126568 (27.07.2017 Gazette 2017/30)**

(54) **EPOXY RESIN COMPOSITION**

EPOXIDHARZZUSAMMENSETZUNG

COMPOSITION DE RÉSINE ÉPOXYDE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.01.2016 JP 2016008372**

(43) Date of publication of application:
**28.11.2018 Bulletin 2018/48**

(73) Proprietor: **New Japan Chemical Co., Ltd.**
**Kyoto 612-8224 (JP)**

(72) Inventors:
- **NAGASHIMADA, Takayuki**
**Kyoto-shi**
**Kyoto 612-8224 (JP)**
- **HARADA, Eriko**
**Kyoto-shi**
**Kyoto 612-8224 (JP)**

(74) Representative: **Vossius & Partner**
**Patentanwälte Rechtsanwälte mbB**
**Siebertstrasse 3**
**81675 München (DE)**

(56) References cited:
**WO-A1-2014/006855** **WO-A1-2014/171529**
**WO-A1-2014/171529** **JP-A- H09 328 535**
**JP-A- 2000 204 137** **JP-A- 2002 080 557**
**JP-A- 2005 325 178** **JP-A- 2007 314 740**
**JP-A- 2008 179 733** **JP-A- 2012 132 028**
**JP-A- 2015 117 363**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 406 645 B1

## Description

Technical Field

The present invention relates to an epoxy resin composition.

Background Art

Cured epoxy resin products obtained by curing an epoxy resin composition are excellent in heat resistance, adhesion to substrates, chemical resistance, waterproofness, mechanical strength, electrical characteristics, and the like; thus, these cured epoxy resin products have wide-ranging applications in the fields of coating compositions, civil engineering, adhesion, and electricity.

Recent developments in portable electronic devices, including cellular phones, digital cameras, and laptop computers, reflect the trend in electronic components, such as semiconductor devices (transistors, field-effect transistors (FET), thyristors (SCR), diodes (rectifiers)) and optical semiconductors (e.g., photocouplers, light-emitting diodes (LED), and photo interrupters), of becoming smaller and thinner in line with their higher density and higher integration. The following high-integration techniques reducing mounting area have been developed for semiconductor packages containing combined semiconductor devices: for example, BGA (ball grid array), CSP (chip-scale package), COG (chip on glass), COB (chip on board), MCM (multichip module), and LGA (land grid array). Surface-mountable chip-type semiconductors have also been developed for LED optical semiconductors.

Because these semiconductor devices themselves are highly exothermic, the sealing materials must have excellent heat resistance as well as excellent workability, and, when cured, excellent electrical properties, mechanical characteristics, adhesion to substrates, waterproofness, and solvent resistance. For this reason, liquid epoxy resins are typically used.

Acid anhydrides are widely used as curing agents for such liquid epoxy resins because acid anhydrides are easy to work with due to their low viscosity and exhibit excellent wettability and adhesion to semiconductor devices, and excellent electrical properties, mechanical characteristics, and heat resistance. Depending on the intended use, various types of acid anhydrides are suitably selected. Examples of acid anhydrides for use in curing agents for epoxy resin sealing materials for semiconductor packages include methyltetrahydrophthalic anhydride, methylhexahydrophthalic anhydride, hexahydrophthalic anhydride, methyl nadic anhydride, and hydrogenated methyl nadic anhydride.

After a device is bare-chip mounted on a substrate, a sealing material is typically applied over it to form a thin film (e.g., 2 mm or less) by a dispenser technique, ordinary-pressure screen printing, or vacuum-screen printing; or the device is potted in the sealing material; or the space between the semiconductor device and the substrate is impregnated with the material. Additionally, the coated, potted, or impregnated product with the sealing material is typically stored for a predetermined period of time and subjected to heat curing in a hardening furnace, such as an air-circulating oven.

However, when a liquid epoxy resin composition is cured using a conventional acid anhydride curing agent to form a thin film, problems such as yellowing immediately after curing, a decrease in glass-transition temperature (Tg) of the cured product, and crack formation arise. In particular, preventing yellowing is a technical problem to be solved when colorlessness and transparency are required in applications of the composition. This has limited the use of epoxy resin thin films obtained by using an acid anhydride curing agent to applications in which yellowing has low impact (e.g., red LEDs); it has been difficult to use the films when yellowing affects quality (e.g., blue or white LEDs)

To solve these problems, an epoxy resin composition containing as a curing agent a hydrogenated methyl nadic anhydride that contains impurities in a specific amount or less has been proposed (PTL 1). However, this epoxy resin composition needs further improvement in initial colorlessness and transparency (i.e., a low yellow index immediately after curing, as well as colorlessness and transparency) and thermal yellowing resistance (i.e., a property of inhibiting yellowing caused by heat) when used with an imidazole-based cure accelerator.

Due to their excellent curability, compounds having an annular amidine structure such as DBU (1,8-diazabicyclo(5.4.0)undec-7-ene) and DBN (1,5-diazabicyclo[4.3.0]non-5-ene) and ammonium-salt-based cure accelerators have been widely used in LEDs, for example. However, when these cure accelerators are used for epoxy resin compositions, the initial colorlessness and transparency of the cured epoxy resin products in the form of thin film deteriorate.

An epoxy resin composition for laminates containing an acid anhydride as a curing agent and a quaternary phosphonium salt as a cure accelerator is disclosed as exhibiting a fast curing rate and excellent moldability (PTL 2). However, the patent literature nowhere suggests a technical solution to solve the yellowing problem of a cured product that occurs when an epoxy resin composition is cured to form a thin film. In fact, a cured epoxy resin product obtained by using tetrabutylphosphonium bromide disclosed in the patent literature, which is commonly available as a quaternary phosphonium salt, as a cure accelerator seriously deteriorates in initial colorlessness and transparency when the resin is cured in the form of a thin film.

A liquid epoxy resin composition containing an acid anhydride as a curing agent and tetrabutylphosphonium

octate as a cure accelerator is disclosed as a composition that exhibits excellent transparency when used as a sealing material (Patent Literature 3). However, when the composition containing an alicyclic epoxy resin as an epoxy resin is used, the initial colorlessness and transparency of the cured thin-film product significantly deteriorates.

Additionally, sealing materials used for chip-form LEDs, in particular those that are often used outdoors and exposed to ultraviolet rays, are required to exhibit not only colorlessness and transparency but also weatherability; thus, compounds having no aromatic ring in the molecule such as 3,4-epoxycyclohexylmethyl-3'4'-epoxycyclohexane carboxylate are used as an epoxy resin, and non-aromatic acid anhydrides such as methylhexahydrophthalic anhydride and hexahydrophthalic anhydride are used as an acid anhydride.

When epoxy resin compositions are used in adhesive materials or coating materials, the cured epoxy resin products are desired to have high adhesion to a variety of substrates (e.g., metal and plastic). For example, due to its excellent transparency, use of an epoxy resin composition containing an acid-anhydride-based curing agent in optics fields, such as for liquid crystal displays, organic EL lighting, and touchscreens, has been explored (PTL 4). For optical film substrates, polyester films, in particular polyethylene terephthalate (PET) films, have been used because of their excellent optical properties, mechanical strength, and durability; improvement is thus required in adhesion between a cured epoxy resin product and a PET film.

Polycarbonate resins have also been used in glazing materials for automobiles, such as for panoramic roofs and rear windshields, because of the extremely excellent transparency, easy moldability, heat resistance, and impact resistance, and they are highly valued as automotive components from the standpoint of weight reduction in aiming to improve fuel efficiency of automobiles and variety in design. However, polycarbonate resins are inferior in abrasion resistance and weatherability as compared to other plastics and are prone to defects in appearance, such as scratches caused by dust or washing, decreased transparency due to ultraviolet rays in sunlight, and crack formation. Thus, it is essential to form a cured coating film on the polycarbonate surface to add abrasion resistance and weatherability to the surface.

To compensate for the shortcomings of polycarbonate resins, a method for forming a cured coating film has been developed, in which the method includes applying a coating material composition containing a resin, such as acrylic-based resin and silicon-based resin, and an ultraviolet absorber onto the surface of a polycarbonate molded article and curing the composition to form a coating film (PTL 5).

Nonetheless, most cured coating films may exhibit decreased adhesion to polycarbonate resins over time when exposed outdoors for a long time. Thus, further improvement in adhesion is needed.

To prevent a decrease in adhesion, a method has been proposed in which an additive for improving adhesion is added to a coating material composition (Patent Literature 6). However, while the use of an additive improves initial adhesion, it is difficult to achieve both excellent weatherability of a cured coating film (change in appearance) and its excellent adhesion to a polycarbonate resin for a prolonged period of time.

Resin molded articles described as having excellent heat resistance, transparency, thermal yellowing resistance, surface hardness, solvent resistance, flexibility, and adhesiveness are disclosed in WO 2014/171529 A1, wherein the compositions comprise (A) an epoxy resin, (B) a polycarboxylic anhydride, and (C) a phosphonium accelerator.

Citation List

Patent Literature

PTL 1: JP2003-002951A
PTL 2: JPH11-158251A
PTL 3: JPH07-196774A
PTL 4: JP2012-132028A
PTL 5: JPS56-122840A
PTL 6: JPH09-302268A


Summary of Invention

Technical Problem

The main object of the present invention is to provide an epoxy resin composition capable of forming a cured epoxy resin product that exhibits excellent initial transparency and weatherability and excellent adhesion to various substrates. Solution to Problem

The present inventors conducted extensive research on epoxy resin compositions to solve the problems described above and found the following.

(i) Selecting a specific polycarboxylic anhydride as a curing agent led to excellent initial transparency of a cured epoxy resin product.
(ii) Selecting a combination of a specific polycarboxylic anhydride as a curing agent and a specific phosphonium compound as a cure accelerator led to excellent weatherability of a cured epoxy resin product.
(iii) A cured epoxy resin product excellent in initial transparency and weatherability was obtained by using an epoxy resin composition containing (A) an epoxy resin, (B) a specific polycarboxylic anhydride, and (C) a specific phosphonium compound.
(iv) The obtained cured epoxy resin product was excellent in adhesion to various substrates.

The present invention was completed based on these findings and provides the following epoxy resin compositions and the like.

Advantageous Effects of Invention

The epoxy resin composition according to the present invention is capable of forming a cured epoxy resin product that exhibits excellent initial transparency and weatherability and excellent adhesion to various substrates. Moreover, in addition to this feature, the epoxy resin composition according to the present invention is capable of forming a cured epoxy resin product that exhibits excellent heat resistance and water vapor barrier properties.

Description of Embodiments

The epoxy resin composition according to the present invention comprises the following components (A) to (C):

(A) an epoxy resin;
(B) a polycarboxylic anhydride containing the structural unit represented by formula (1)

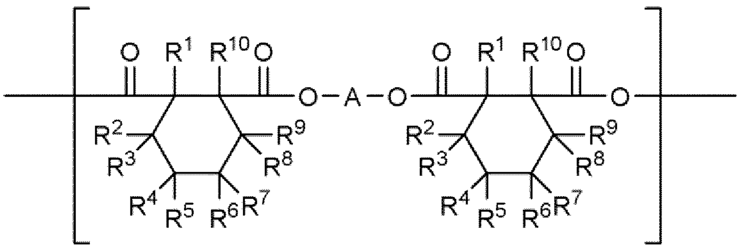

(1)

wherein A represents a cycloalkylene group or a group in which two or more cycloalkylene groups are bonded via a single bond or a divalent group, the cycloalkylene group or the two or more cycloalkylene groups being optionally substituted;
$R^1$ to $R^{10}$ are identical or different and each represent a hydrogen atom or an optionally substituted $C_{1-10}$ alkyl group, two groups of $R^1$ to $R^{10}$ may be taken together to form a divalent group; and

(C) a phosphonium compound represented by formula (2)

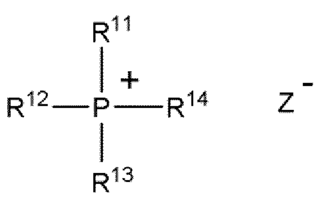

(2)

wherein $R^{11}$ to $R^{14}$ are identical or different and each represent a $C_{1-18}$ alkyl group or an optionally substituted aryl group, and $Z^-$ represents an organic anion.

Epoxy Resin (A)

The epoxy resin (A) is not particularly limited, and widely used conventional epoxy resins can be used. Examples of epoxy resins include bisphenol-type epoxy resins obtained by a reaction between a bisphenol, such as bisphenol A, bisphenol S, bisphenol F, and biphenol, and epichlorohydrin; phenol novolac-type epoxy resins obtained by a reaction between phenol novolac and epichlorohydrin; glycidyl ester-type epoxy resins obtained by a reaction between a polyvalent carboxylic acid and epichlorohydrin; glycidyl ether-type epoxy resins obtained by a reaction between a polyhydric alcohol and epichlorohydrin; amine-type epoxy resins; alicyclic epoxy resins; alicyclic glycidyl ether-type epoxy resins; triazine-type epoxy resins; and glycoluril-type epoxy resins.

Specific examples of bisphenol-type epoxy resins include bisphenol A-type epoxy resin, bisphenol F-type epoxy resin, bisphenol S-type epoxy resin, bisphenol AD-type epoxy resin, and biphenol-type epoxy resin.

Specific examples of novolac-type epoxy resins include phenol novolac-type epoxy resin and cresol novolac-type epoxy resin.

Specific examples of glycidyl ester-type epoxy resins include diglycidyl hexahydrophthalate and diglycidyl tetrahydrophthalate.

Specific examples of glycidyl ether-type epoxy resins include 1,4-cyclohexane dimethanol diglycidyl ether, diglycidyl ether of bisphenol A-alkylene oxide adduct, diglycidyl ether of hydrogenated bisphenol A-alkylene oxide adduct, and diglycidyl ethers of polypropylene glycols, and pentaerythritol polyglycidyl ether.

Specific examples of amine-type epoxy resins include triglycidyl-p-amino phenol, triglycidyl isocyanurate, monoallyl diglycidyl isocyanurate, tetraglycidyl meta-xylenediamine, tetraglycidyl diaminodiphenylmethane, and tetraglycidyl-1,3-bis aminomethyl cyclohexane.

Specific examples of alicyclic epoxy resins include 3,4-epoxycyclohexylmethyl-3',4'-epoxycyclohexane carboxylate.

Specific examples of alicyclic glycidyl ether-type epoxy resins include hydrogenated bisphenol A-type epoxy resin, hydrogenated bisphenol A diglycidyl ether-type epoxy resins, and hydrogenated bisphenol F-type epoxy resin.

Specific examples of triazine-type epoxy resins include 1,3,5-tris(2,3-epoxypropyl)-1,3,5-triazine-2,4,6(1H,3H,5H)-trione, a mixture of a reaction product between 1,3,5-tris(2,3-epoxypropyl)-1,3,5-triazine-2,4,6(1H,3H,5H)-trione and propionic anhydride with 1,3,5-tris(2,3-epoxypropyl)-1,3,5-triazine-2,4,6(1H,3H,5H)-trione, and epoxy-modified 1,3,5-tris(2,3-epoxypropyl)-1,3,5-triazine-2,4,6(1H,3H,5H)-trione.

Specific examples of glycoluril-type epoxy resins include 1,3,4,6-tetraglycidyl glycoluril.

Of these epoxy resins, alicyclic glycidyl ether-type epoxy resins, triazine-type epoxy resins, and glycoluril-type epoxy resins are preferable because the use of these resins can form a cured epoxy resin product that exhibits better weatherability.

These epoxy resins can be used singly or in a combination of two or more.

Polycarboxylic Anhydride (B)

The polycarboxylic anhydride (B) contains the structural unit represented by formula (1)

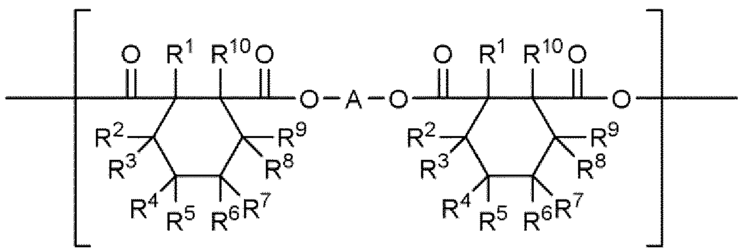

(1)

wherein A represents a cycloalkylene group or a group in which two or more cycloalkylene groups are bonded via a single bond or a divalent group, the cycloalkylene group or the two or more cycloalkylene groups being optionally substituted; and $R^1$ to $R^{10}$ are identical or different and each represent a hydrogen atom or an optionally substituted $C_{1-10}$ alkyl group, and two groups of $R^1$ to $R^{10}$ may be taken together to form a divalent group.

The polycarboxylic anhydride can be obtained by performing a condensation reaction in a reaction liquid containing a dicarboxylic acid compound represented by formula (17)

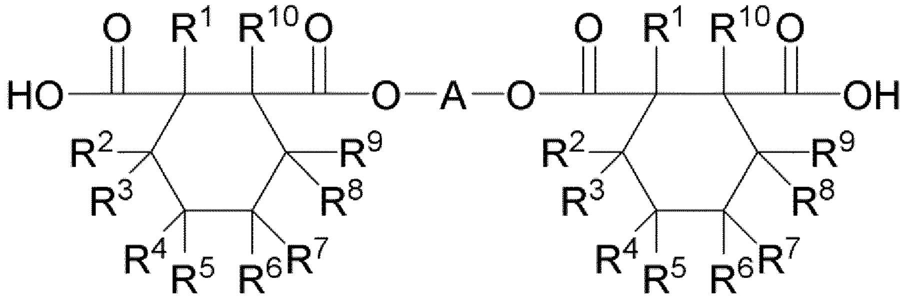

(17)

wherein A and $R^1$ to $R^{10}$ are as defined in formula (1) .

A in formula (1) represents a cycloalkylene group or a group in which two or more cycloalkylene groups are bonded via a single bond or a divalent group.

When A in formula (1) is a group in which two or more cycloalkylene groups are bonded via a single bond or a divalent group, examples of the group include a divalent group represented by formula (3)

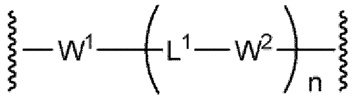

(3)

wherein $W^1$ and $W^2$ are identical or different and each represent an optionally substituted $C_{3-30}$ cycloalkylene group; $L^1$ represents a single bond, an optionally substituted $C_{1-10}$ alkylene group, an optionally substituted $C_{3-30}$ cycloalkylene group, an optionally substituted $C_{3-30}$ cycloalkylidene group, -O-, -S-, -CO-, -SO-, or - $SO_2$-; n represents an integer of 0 or 1; and the wavy lines represent an attachment site.

When A is a divalent group represented by formula (3), the polycarboxylic anhydride contains the structural unit represented by formula (18)

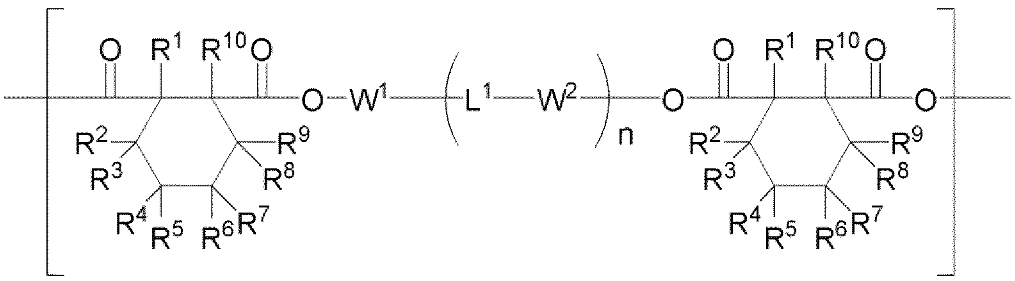

(18)

wherein $W^1$, $W^2$, $L^1$, and n are as defined in formula (3) ; and $R^1$ to $R^{10}$ are as defined in formula (1) .

The polycarboxylic anhydride containing the structural unit represented by formula (18) can be obtained by performing a condensation reaction in a reaction liquid containing a dicarboxylic acid compound represented by formula (19)

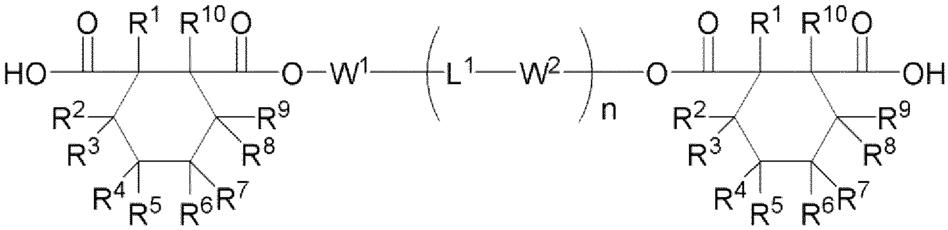

(19)

wherein $W^1$, $W^2$, $L^1$, and n are as defined in formula (3) ; and $R^1$ to $R^{10}$ are as defined in formula (1) .

The polycarboxylic anhydride containing the structural unit represented by formula (1) or formula (18) includes a compound having a carboxyl group (-COOH) at each end, and a polycarboxylic anhydride in which the hydrogen atom of the carboxyl group at each end is replaced by a group represented by formula (20)

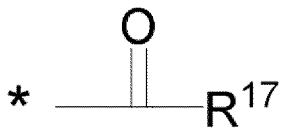 (20)

wherein $R^{17}$ represents an optionally substituted $C_{1-10}$ alkyl group or an optionally substituted $C_{3-30}$ cycloalkyl group, and the symbol * represents an attachment site.

Of these, a polycarboxylic anhydride in which the hydrogen atom of the carboxyl group at each end is replaced by a group represented by formula (20) is preferable.

Specific examples of the polycarboxylic anhydride in which the hydrogen atom of the carboxyl group at each end is replaced by a group represented by formula (20) include a compound represented by formula (4)

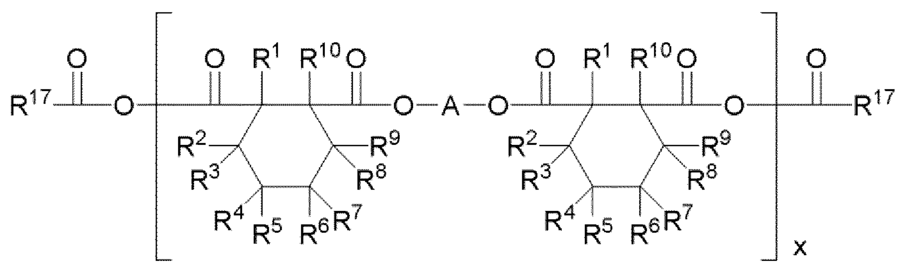 (4)

wherein A and $R^1$ to $R^{10}$ are as defined in formula (1), $R^{17}$ is as defined in formula (20), and x represents an integer of 2 or more, and a compound represented by formula (21)

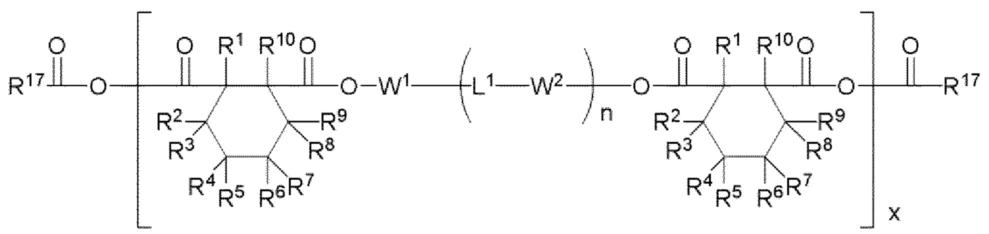 (21)

wherein $W^1$, $W^2$, $L^1$, and n are as defined in formula (3), $R^1$ to $R^{10}$ are as defined in formula (1), $R^{17}$ is as defined in formula (20), and x represents an integer of 2 or more.

The groups in formulas (1), (3), (4), (17) to (19), and (21) are specifically as follows.

In formula (1), when A is a cycloalkylene group, examples of the cycloalkylene group include $C_{3-50}$ cycloalkylene groups. More specific examples include monocyclic cycloalkylene, such as cyclopropylene, cyclobutylene, cyclopentylene, and cyclohexylene; and polycyclic cycloalkylene, such as 7-oxabicyclo[2,2,1]heptylene, decahydronaphthalene (a hydrogenated naphthalene group), norbornylene, and adamantylene. The cycloalkylene groups may optionally be substituted. The substituent includes an alkyl group, a cycloalkyl group, and a halogen atom. The number of substituents is not particularly limited, and is, for example, 1 to 8.

In formula (3), examples of the $C_{3-30}$ cycloalkylene group represented by $W^1$ or $W^2$ include monocyclic cycloalkylene, such as cyclopropylene, cyclobutylene, cyclopentylene, and cyclohexylene; and polycyclic cycloalkylene, such as 7-oxabicyclo[2,2,1]heptylene, decahydronaphthalene (a hydrogenated naphthalene group), norbornylene, and adamantylene. The cycloalkylene groups may optionally be substituted. The substituent includes an alkyl group, a cycloalkyl group, and a halogen atom. The number of substituents is not particularly limited, and is, for example, 1 to 8.

A, $W^1$, and $W^2$ are preferably a divalent group represented by formula (a)

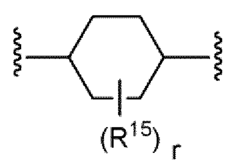 (a)

wherein $R^{15}$ represents an optionally substituted $C_{1-10}$ alkyl group or an optionally substituted $C_{3-30}$ cycloalkyl group; r

represents an integer of 0 to 8, and when r represents 2 to 8, two to eight $R^{15}$ groups may be identical or different, and when r represents 2 to 8, two $R^{15}$ groups may be taken together to form a divalent group or
a divalent group represented by formula (b)

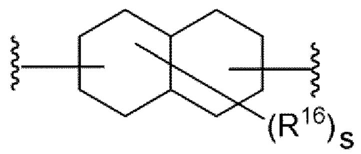
(b)

wherein $R^{16}$ represents an optionally substituted $C_{1-10}$ alkyl group or an optionally substituted $C_{3-30}$ cycloalkyl group; s represents an integer of 0 to 12, and when s represents 2 to 12, two to twelve $R^{16}$ groups may be identical or different, and when s represents 2 to 12, two $R^{16}$ groups may be taken together to form a divalent group; and the wavy lines represent an attachment site.

The divalent group represented by formula (a) (cycloalkylene) includes divalent groups represented by the following formulas (a-1) to (a-8):

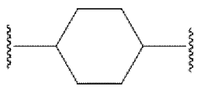
(a-1)
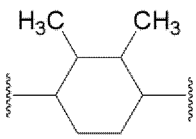
(a-4)
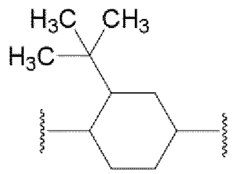
(a-7)
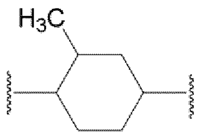
(a-2)
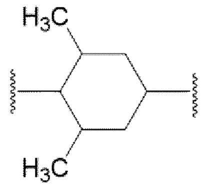
(a-5)
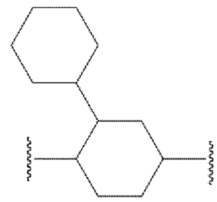
(a-8)
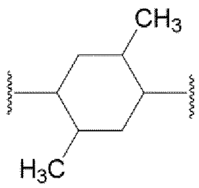
(a-3)
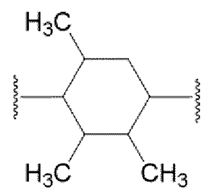
(a-6)

wherein the wavy lines represent an attachment site.

Examples of the divalent group represented by formula (b) (decahydronaphthalene group) include a 2,7-decahydronaphthalene group represented by formula (b-1), a 2,6-decahydronaphthalene group represented by formula (b-2), a 1,6-decahydronaphthalene group represented by formula (b-3), a 1,7-decahydronaphthalene group represented by formula (b-4), a 1,8-decahydronaphthalene group represented by formula (b-5), and a 1,5-decahydronaphthalene group represented by formula (b-6). Of these, a 2,7-decahydronaphthalene group represented by formula (b-1) and a 2,6-decahydronaphthalene group represented by formula (b-2) are preferable:

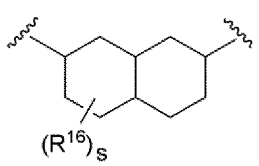
(b-1)
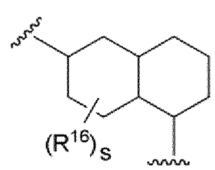
(b-3)
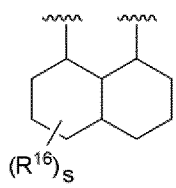
(b-5)

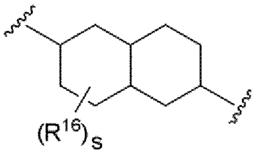 (b-2) 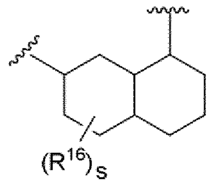 (b-4) 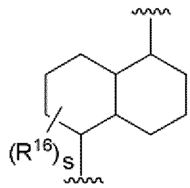 (b-6)

wherein $R^{16}$ and s are as defined in formula (b), and the wavy lines represent an attachment site.

Additionally, the divalent group represented by formula (b) is particularly preferably a divalent group represented by the following formula (b-1-1) or (b-2-1)

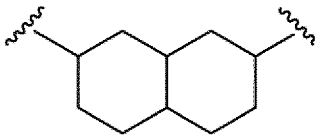 (b-1-1) 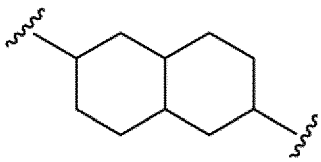 (b-2-1)

wherein the wavy lines represent an attachment site.

In the present specification and claims, groups having one or more attachment sites indicated by a wavy line are not particularly limited in their configuration. The groups may be individually in the configuration as described in this document or may be individually in reversed configuration.

When A in formula (1) is a cycloalkylene group or a group in which two or more cycloalkylene groups are bonded via a single bond or a divalent group, and when $W^1$ and $W^2$ in formula (3) are an optionally substituted $C_{3-30}$ cycloalkylene group, these groups may also be referred to as "groups formed by removing two hydroxyl groups from a cycloalkanediol."

Examples of groups formed by removing two hydroxyl groups from a cycloalkanediol include groups formed by removing two hydroxyl groups from a monocyclic cycloalkanediol, such as 1,2-cyclopropanediol, 1,2-cyclobutanediol, 1,3-cyclobutanediol, 1,2-cyclopentanediol, 1,3-cyclopentanediol, 1,2-cyclohexanediol, 1,3-cyclohexanediol, 1,4-cyclohexanediol, 1,2-cycloheptanediol, 1,3-cycloheptanediol, and 1,4-cycloheptanediol; and groups formed by removing two hydroxyl groups from a polycyclic cycloalkanediol, such as norbornene, dicyclopentadiene diols, adamantane diols, hydrogenated naphthalenediols, and hydrogenated bisphenols, including hydrogenated biphenyl diols, hydrogenated bisphenol A, hydrogenated bisphenol C, hydrogenated bisphenol E, hydrogenated bisphenol F, and hydrogenated bisphenol Z.

Of these, preferable are groups formed by removing two hydroxyl groups from 1,4-cyclohexanediol, a hydrogenated naphthalenediol, or a hydrogenated bisphenol.

$L^1$ in formulas (3), (18), (19), and (21) represents a single bond, an optionally substituted $C_{1-10}$ alkylene group, an optionally substituted $C_{3-30}$ cycloalkylene group, an optionally substituted $C_{3-30}$ cycloalkylidene group, or a divalent group represented by -O-, -S-, -CO-, -SO-, or $-SO_2-$.

The $C_{1-10}$ alkylene group in the optionally substituted $C_{1-10}$ alkylene group represented by $L^1$ is preferably a linear or branched $C_{1-10}$ alkylene group, more preferably a linear $C_{1-10}$ alkylene group, and particularly preferably a linear $C_{1-6}$ alkylene group. The linear $C_{1-6}$ alkylene group includes methylene, ethylene, propylene, butylene, pentylene, and hexylene; of these, methylene is preferable.

Specific examples of $L^1$ that is an optionally substituted methylene group include a group represented by formula (c)

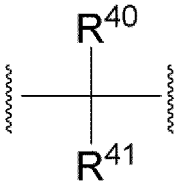 (c)

wherein $R^{40}$ and $R^{41}$ are identical or different and each represent a hydrogen atom, a $C_{1-10}$ alkyl group optionally substituted with one or more halogen atoms, or a $C_{3-30}$ cycloalkyl group optionally substituted with one or more halogen atoms. The wavy lines represent an attachment site.

Of the groups represented by formula (c), preferable are divalent groups represented by formulas (c-1) to (c-8)

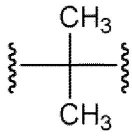 (c-1) 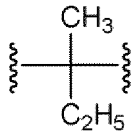 (c-4) 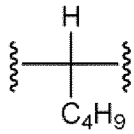 (c-7)

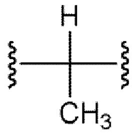 (c-2) 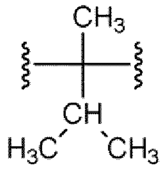 (c-5) 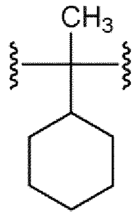 (c-8)

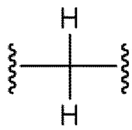 (c-3) 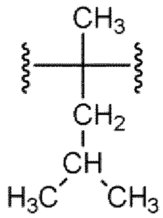 (c-6)

wherein the wavy lines represent an attachment site.

The $C_{3-30}$ cycloalkylene group in the optionally substituted $C_{3-30}$ cycloalkylene group represented by $L^1$ in formulas (3), (18), (19), and (21) is preferably a $C_{3-10}$ cycloalkylene group. The $C_{3-10}$ cycloalkylene group includes a 1,2-cyclopropanediyl group, a 1,2-cyclobutanediyl group, a 1,2-cyclopentanediyl group, a 1,3-cyclopentanediyl group, a 1,2-cyclohexanediyl group, a 1,3-cyclohexanediyl group, and a 1,4-cyclohexanediyl group; of these, a 1,4-cyclohexanediyl group is preferable.

The $C_{3-30}$ cycloalkylidene group in the optionally substituted $C_{3-30}$ cycloalkylidene group represented by $L^1$ in formulas (3), (18), (19), and (21) is preferably a $C_{3-20}$ cycloalkylidene group. The $C_{3-20}$ cycloalkylidene group includes cyclopropylidene, cyclobutylidene, cycloheptylidene, cyclohexylidene, and 3,5,5-trimethylcyclohexylidene; of these, cyclohexylidene and 3,5,5-trimethylcyclohexylidene are preferable.

The $C_{1-10}$ alkyl group in the optionally substituted $C_{1-10}$ alkyl group represented by $R^1$ to $R^{10}$ in formula (1) is preferably a linear or branched $C_{1-10}$ alkyl group, and more preferably a linear or branched $C_{1-6}$ alkyl group. Specific examples include methyl, ethyl, n-propyl, isopropyl, n-butyl, isobutyl, tert-butyl, pentyl, and hexyl. Of these, methyl, ethyl, isobutyl, and tert-butyl are preferable. Examples of substituted $C_{1-10}$ alkyl groups include the above alkyl groups that further have at least one substituent, such as a cycloalkyl group and a halogen atom.

The $C_{1-10}$ alkyl group in the optionally substituted $C_{1-10}$ alkyl group represented by $R^{15}$ in formula (a) is preferably a linear or branched $C_{1-10}$ alkyl group, and more preferably a linear or branched $C_{1-6}$ alkyl group. Specific examples include methyl, ethyl, n-propyl, isopropyl, n-butyl, isobutyl, tert-butyl, pentyl, and hexyl. Of these, methyl, ethyl, isobutyl, and tert-butyl are preferable. Examples of substituted $C_{1-10}$ alkyl groups include the above alkyl groups that further have at least one substituent, such as a cycloalkyl group and a halogen atom. The description for $R^{15}$ in formula (a) is synonymous with the description for the optionally substituted $C_{1-10}$ alkyl group represented by $R^{16}$ in formula (b).

Specific examples of the $C_{3-30}$ cycloalkyl group in the optionally substituted $C_{3-30}$ cycloalkyl group represented by $R^{15}$ in formula (a) include monocyclic cycloalkyl, such as cyclopropyl, cyclobutyl, cyclopentyl, and cyclohexyl; and polycyclic cycloalkyl, such as tetrahydronaphthyl (a hydrogenated naphthyl), norbornyl, and adamantyl, with cyclohexyl being preferable. Examples of substituted $C_{3-30}$ cycloalkyl groups include the above cycloalkyl groups that further have at least one substituent, such as an alkyl group, a cycloalkyl group, and a halogen atom. The description for $R^{15}$ in formula (a) is synonymous with the description for the optionally substituted $C_{3-30}$ cycloalkyl group represented by $R^{16}$ in formula (b).

The $C_{1-10}$ alkyl group in the optionally substituted $C_{1-10}$ alkyl group represented by $R^{17}$ is preferably a linear or branched $C_{1-10}$ alkyl group, and more preferably a linear or branched $C_{1-6}$ alkyl group. Specific examples include methyl, ethyl, n-propyl, isopropyl, n-butyl, isobutyl, tert-butyl, pentyl, and hexyl. Of these, methyl, ethyl, isobutyl, and tert-butyl are preferable. Examples of substituted $C_{1-10}$ alkyl groups include the above alkyl groups that further have at least one substituent, such as a cycloalkyl group and a halogen atom.

Specific examples of the $C_{3-30}$ cycloalkyl group in the optionally substituted $C_{3-30}$ cycloalkyl group represented by $R^{17}$ include monocyclic cycloalkyl, such as cyclopropyl, cyclobutyl, cyclopentyl, and cyclohexyl; and polycyclic cycloalkyl, such as tetrahydronaphthyl (hydrogenated naphthyl), norbornyl, and adamantyl, with cyclohexyl being preferable. Examples of substituted $C_{3-30}$ cycloalkyl groups include the above cycloalkyl groups that further have at least one

substituent, such as an alkyl group, a cycloalkyl group, and a halogen atom.

The $C_{1-10}$ alkyl group optionally substituted with one or more halogen atoms represented by $R^{40}$ or $R^{41}$ is preferably a linear or branched $C_{1-10}$ alkyl group optionally substituted with one or more halogen atoms. Specific examples include unsubstituted $C_{1-6}$ alkyl groups, such as methyl, ethyl, n-propyl, isopropyl, n-butyl, isobutyl, tert-butyl, pentyl, and hexyl; and $C_{1-6}$ haloalkyl, such as trifluoromethyl, pentafluoroethyl, and trichloromethyl. Of these, methyl, ethyl, isobutyl, and trifluoromethyl are preferable.

Specific examples of $C_{3-30}$ cycloalkyl groups optionally substituted with one or more halogen atoms represented by $R^{40}$ or $R^{41}$ include monocyclic cycloalkyl, such as cyclopropyl, cyclobutyl, cyclopentyl, and cyclohexyl; and polycyclic cycloalkyl, such as tetrahydronaphthyl (hydrogenated naphthyl), norbornyl, and adamantyl, with cyclohexyl being preferable. The $C_{3-30}$ cycloalkyl group substituted with one or more halogen atoms includes the above cycloalkyl groups that further have at least one halogen atom.

In the present specification and claims, examples of the halogen atom as a substituent include fluorine, chlorine, bromine, and iodine, with fluorine and chlorine being preferable.

When two groups of $R^1$ to $R^{10}$ in formula (1) are taken together to form a divalent group, examples of the divalent group include an alkylene group.

When two groups of $R^1$ to $R^{10}$ in formula (1) are taken together to form an alkylene group, the group represented by formula (d) below

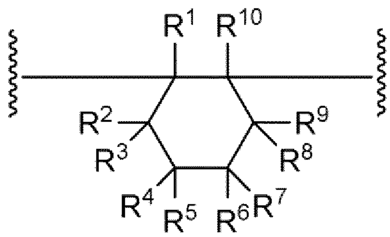
(d)

wherein $R^1$ to $R^{10}$ are as defined in formula (1), and the wavy lines represent an attachment site,
specifically includes a group represented by (d-1) below

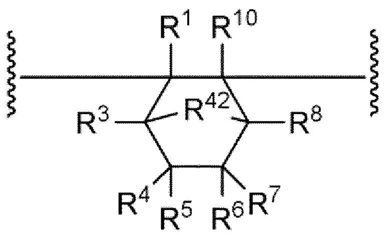
(d-1)

wherein $R^1$, $R^3$ to $R^8$, and $R^{10}$ are as defined in formula (1), $R^{42}$ represents an optionally substituted alkylene group, and the wavy lines represent an attachment site.

Examples of the alkylene group include a linear $C_{1-4}$ alkylene group. The alkylene group is preferably $C_{1-4}$ alkylene, such as methylene, ethylene, propylene, and butylene, and preferably methylene and ethylene.

Of the groups represented by formula (d-1), particularly preferable are groups represented by formula (d-1-1), groups represented by formula (d-1-2), and groups represented by formula (d-1-3)

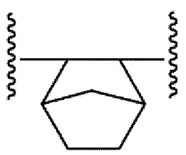
(d-1-1)
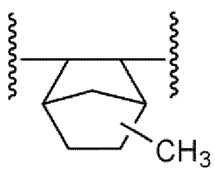
(d-1-2)
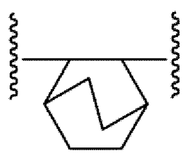
(d-1-3)

wherein the wavy lines represent an attachment site.

When r represents 2 to 8 in formula (a), two $R^{15}$ groups may be taken together to form a divalent group. Examples of the divalent group include an optionally substituted alkylene group, and an optionally substituted $C_{1-10}$ alkylene group is preferable. The optionally substituted $C_{1-10}$ alkylene group is as defined for $L^1$ above.

When s represents 2 to 12 in formula (b), two $R^{16}$ groups may be taken together to form a divalent group.

Examples of the divalent group include an optionally substituted alkylene group, and an optionally substituted $C_{1-10}$ alkylene group is preferable. The optionally substituted $C_{1-10}$ alkylene group is as defined for $L^1$ above.

For the thus-obtained polycarboxylic anhydrides, their trans-form or cis-form isomers may be present, depending on the steric configuration of two alcohol groups or two carboxyl groups. To provide the effects of the present invention, either the trans-form isomer or the cis-form isomer, or a mixture of both isomers, is usable.

x in formulas (4) and (21) represents an integer of 2 or more, preferably 2 to 100, and more preferably 4 to 20. x represents the average number of units in the polymer and can be determined by gel permeation chromatography (GPC).

The number average molecular weight of the polycarboxylic anhydride is preferably within the range of 500 to 6000, and more preferably within the range of 2000 to 6000. The number average molecular weight is measured by a known technique (e.g., gel permeation chromatography (GPC)), and determined as a number average molecular weight (Mn) on a polystyrene basis.

The acid anhydride equivalent of the polycarboxylic anhydride is preferably within the range of 300 to 5000 g/eq, more preferably 500 to 3000 g/eq, and particularly preferably 600 to 1500 g/eq. The acid anhydride equivalent is calculated by using the equation described in the Examples later.

The polycarboxylic anhydride rarely volatizes in the temperature range within which an epoxy resin is typically cured.

<u>Method for Producing Polycarboxylic Anhydride</u>

The method for producing the polycarboxylic anhydride according to the present invention is not particularly limited, as long as a compound containing the structural unit represented by formula (1) is obtained.

The polycarboxylic anhydride according to the present invention is produced, for example, as described in the following reaction scheme.

Reaction Scheme

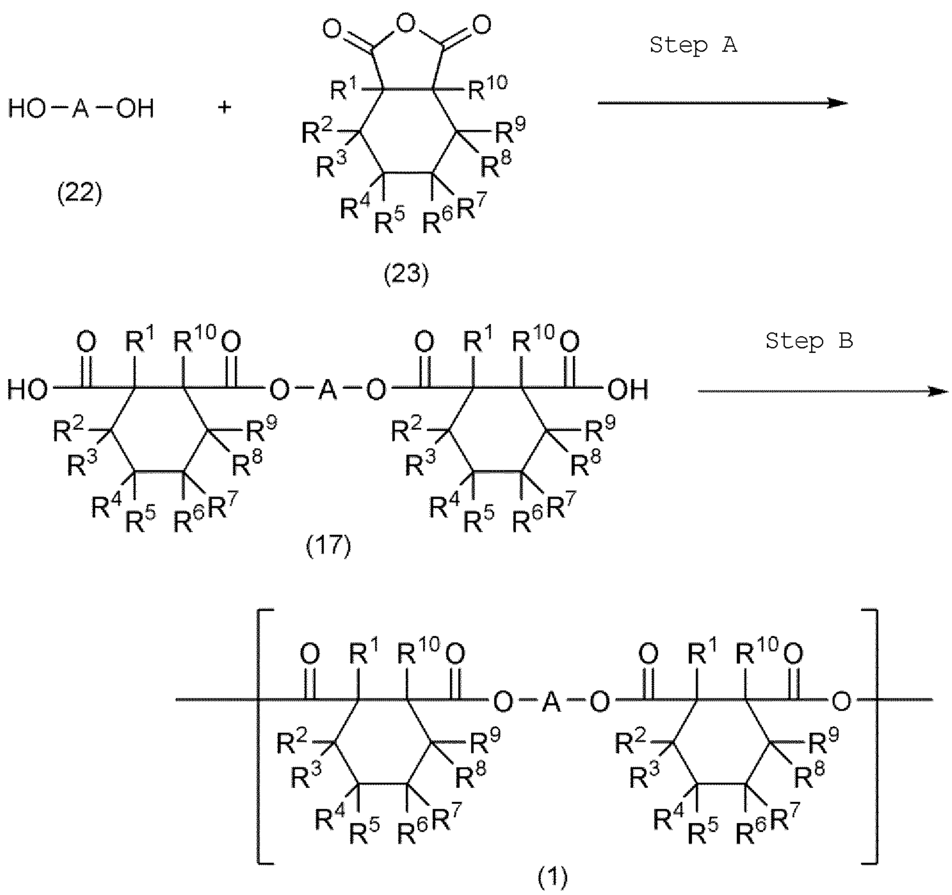


(22)

(23)

(17)

(1)

wherein A and $R^1$ to $R^{10}$ are as defined in formula (1) .

Specifically, the method for producing the polycarboxylic anhydride according to the present invention includes the step of reacting a diol compound represented by formula (22) with a carboxylic anhydride represented by formula (23) to obtain a dicarboxylic acid compound represented by formula (17) (step A) and the step of performing a condensation reaction in a reaction liquid containing the dicarboxylic acid compound obtained in step A to produce a polycarboxylic anhydride containing the structural unit represented by formula (1) (step B).

The condensation reaction in step B may be performed in the presence of a condensation agent. When the reaction is performed in the presence of a condensation agent, the polycarboxylic anhydride produced is a compound represented by formula (4)

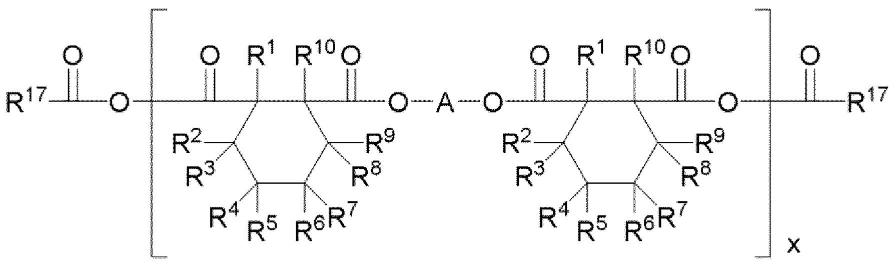

(4)

wherein A and $R^1$ to $R^{10}$ are as defined in formula (1), $R^{17}$ represents an optionally substituted $C_{1-10}$ alkyl group or an optionally substituted $C_{3-30}$ cycloalkyl group, and x represents an integer of 2 or more.

Step A

In step A, a diol compound represented by formula (22) and a carboxylic anhydride represented by formula (23) are reacted, thereby producing a dicarboxylic acid compound represented by formula (17).

The reaction in step A may be performed using a typical method for reacting a diol compound and a carboxylic anhydride, and the method is not particularly limited.

The reaction in step A is performed in a suitable solvent or in the absence of a solvent.

When a solvent is used, examples of the solvent include aromatic hydrocarbon solvents, such as benzene, toluene, and xylene; halogenated hydrocarbon solvents, such as dichloromethane, chloroform, and dichloroethane; amide solvents, such as N-methylpyrrolidone (NMP), N,N-dimethylacetamide, and N,N-dimethylformamide; ketone solvents, such as acetone, methyl ethyl ketone, methyl isobutyl ketone, diisobutyl ketone, 2-heptanone, 4-heptanone, 2-octanone, cyclopentanone, cyclohexanone, and acetylacetone; glycol ether solvents, such as ethylene glycol monobutyl ether, diethylene glycol monobutyl ether, propylene glycol monomethyl ether, propylene glycol monobutyl ether, dipropylene glycol dimethyl ether, and propylene glycol monomethyl ether acetate; ester solvents, such as $\gamma$-butyrolactone and butyl acetate; and mixture solvents of these solvents. Of these, cyclohexanone, butyl acetate, and diethylene glycol monobutyl ether acetate are particularly preferable.

The amount of the solvent for use is typically 0.1 to 50 wt%, and preferably 10 to 30 wt%, per mol of the diol compound represented by formula (22).

The amount of the carboxylic anhydride represented by formula (23) may be suitably adjusted. For example, the amount is typically 1.8 to 3 mol, and preferably 2 to 2.2 mol, per mol of the diol compound represented by formula (19).

The reaction temperature in step A is typically preferably within the range of 50 to 150°C, and more preferably 90 to 120°C, although the reaction temperature varies depending on the type of starting material compounds for use and the like.

The reaction time in step A is typically preferably within the range of 0.5 to 10 hours, and more preferably 1 to 5 hours, although the reaction time varies depending on the type of starting material compounds for use, reaction temperature, and the like.

Step B

In step B, a condensation reaction is performed in a reaction liquid containing the dicarboxylic acid compound represented by formula (17) obtained in step A, thereby producing a polycarboxylic anhydride.

The reaction in step B may be performed using a typical method for condensation reaction of dicarboxylic acid compounds.

The reaction in step B is performed in a suitable solvent or in the absence of a solvent.

The type of the solvent for use in step B may be identical to or different from the solvent used in step A.

When a solvent is used, the amount of the solvent may be suitably adjusted. For example, the amount is typically 0.1 to 500 wt%, and preferably 200 to 400 wt%, per mol of the dicarboxylic acid compound represented by formula (12).

The condensation reaction in step B may be performed in the presence of a condensation agent. When the condensation reaction is performed in the presence of a condensation agent, examples of the condensation agent include carboxylic anhydrides, such as acetic anhydride, propionic anhydride, and bis(cyclohexanecarboxylic acid) anhydride. Of these compounds, acetic anhydride is particularly preferable.

The amount of the condensation agent for use may be suitably adjusted. For example, the amount is typically 3 to 7 mol, and preferably 3 to 4 mol, per mol of the dicarboxylic acid compound represented by formula (17).

A specific example is that when acetic anhydride is used as a condensation agent, it is preferable, in order to facilitate the condensation reaction, to perform the reaction while distilling off the acetic acid generated as a by-product over the course of the reaction outside the reaction system. When a solvent is used, the following condensation reaction method may also be used: while the solvent is added dropwise to the reaction system, the solvent is distilled off together with the by-product acetic acid.

The reaction temperature in step B is typically preferably within the range of 50 to 150°C, and more preferably 90 to 120°C, although the reaction temperature varies depending on the type of starting material compounds for use and the like.

The reaction time in step B is typically preferably within the range of 0.5 to 20 hours, and more preferably 1 to 10 hours, although the reaction time varies depending on the type of starting material compounds for use, reaction temperature, and the like.

Step B may be performed after the compound obtained in the reaction in step A has been purified, or consecutively performed after step A without purification.

The reaction described above (reaction scheme) may be performed under ordinary pressure, reduced pressure, or increased pressure. The atmosphere in which the reaction is performed is not particularly limited as long as the reaction is not hindered. For example, the atmosphere may be any of the following: air atmosphere, nitrogen atmosphere, argon atmosphere, and the like. The reaction described above may be performed by any of the following methods: a batch method, a semibatch method, a continuous method, and the like.

The individual compounds obtained above (in the reaction scheme) can be separated and purified from the reaction mixture by a separating technique, such as filtration, concentration, extraction, crystallization, recrystallization, column chromatography, or a combination of these techniques.

The polycarboxylic anhydride according to the present invention may also be used as a composition containing a solvent for various purposes without performing separation and purification.

The polycarboxylic anhydride of the present invention described above is used for a curing agent for epoxy resins.

The polycarboxylic anhydride can be used singly as a curing agent for epoxy resin; in a preferable embodiment, the polycarboxylic anhydride is mixed with a cure accelerator, and the mixture is used for a curing agent for epoxy resin.

The polycarboxylic anhydride for epoxy resin according to the present invention may be used singly or in a combination of two or more.

The polycarboxylic anhydride for epoxy resin according to the present invention may be dissolved in a solvent and used as a solution. In this case, to obtain an excellent coating film, the concentration of the polycarboxylic anhydride is preferably 5 to 60 wt%, and more preferably 10 to 50 wt% in the solution.

Phosphonium Compound (C)

The phosphonium compound (C) is represented by formula (2)

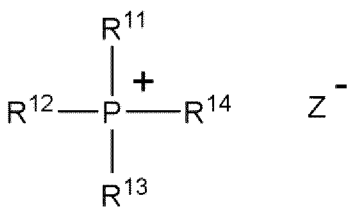

(2)

wherein $R^{11}$ to $R^{14}$ are identical or different and each represent a $C_{1\text{-}18}$ alkyl group or an optionally substituted $C_{6\text{-}18}$ aryl group; and $Z^-$ represents an organic anion.

The phosphonium compound represented by formula (2) may be used singly or in a combination of two or more.

In formula (2), $R^{11}$ to $R^{14}$ are identical or different and each represent a $C_{1\text{-}18}$ alkyl group or an optionally substituted $C_{6\text{-}18}$ aryl group.

The $C_{1\text{-}18}$ alkyl group represented by $R^{11}$ to $R^{14}$ is preferably a linear or branched $C_{1\text{-}18}$ alkyl group, more

preferably a linear or branched $C_{1-6}$ alkyl group, and preferably a branched $C_{3-6}$ alkyl group. Examples of these alkyl groups include methyl, ethyl, n-propyl, isopropyl, n-butyl, isobutyl, sec-butyl, tert-butyl, n-pentyl, isopentyl, sec-pentyl, tert-pentyl, neopentyl, n-hexyl, isohexyl, sec-hexyl, tert-hexyl, and neohexyl. Of these, n-butyl is preferable.

Examples of the optionally substituted $C_{6-18}$ aryl group represented by $R^{11}$ to $R^{14}$ include 1- to 3-ring aryl groups, such as phenyl, toluyl, xylyl, naphthyl, anthryl, and phenanthryl, with phenyl being preferable.

The phosphonium cation in the phosphonium compound represented by formula (2) is preferably a tetrabutylphosphonium cation, in which $R^{11}$ to $R^{14}$ are all a butyl group, which is, in particular, an n-butyl group (in particular, a tetra n-butyl phosphonium cation), or a tetraphenylphosphonium cation, in which $R^{11}$ to $R^{14}$ are all a phenyl group.

The organic anion ($Z^-$) in the phosphonium compound represented by formula (2) preferably contains the structure represented by formula (5)

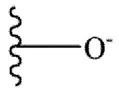

(5)

wherein the wavy line represents an attachment site;
the structure represented by formula (6)

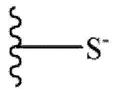

(6)

wherein the wavy line represents an attachment site;
the structure represented by formula (7)

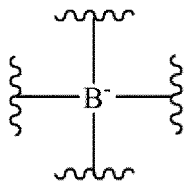

(7)

wherein the wavy lines represent an attachment site; or
the structure represented by formula (8)

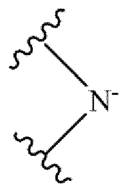

(8)

wherein the wavy lines represent an attachment site.

Examples of the organic anion ($Z^-$) containing the structure represented by formula (5) include an aliphatic monocarboxylic acid anion represented by formula (9)

$$R^{18}COO^- \quad (9)$$

wherein $R^{18}$ represents a $C_{1-17}$ alkyl group.

The $C_{1-17}$ alkyl group represented by $R^{18}$ in formula (9) is preferably a linear or branched $C_{1-17}$ alkyl group, more preferably a linear or branched $C_{7-17}$ alkyl group, and still more preferably a linear $C_{7-15}$ alkyl group.

Specific examples of the aliphatic monocarboxylic acid anion include an n-octanoic acid anion, an n-nonanoic acid anion, an n-decanoic acid anion, an n-undecanoic acid anion, a lauric acid anion, a myristic acid anion, a palmitic acid anion, a stearic acid anion, a 2-ethylhexanoic acid anion, an isononanoic acid anion, an isodecanoic acid anion, an isoundecanoic acid anion, and an isostearic acid anion. Preferable are an n-octanoic acid anion, an n-nonanoic acid anion, an n-decanoic acid anion, an n-undecanoic acid anion, a lauric acid anion, a myristic acid anion, and a palmitic acid anion.

Examples of the organic anion ($Z^-$) containing the structure represented by formula (5) include an alicyclic

dicarboxylic acid anion represented by formula (10)

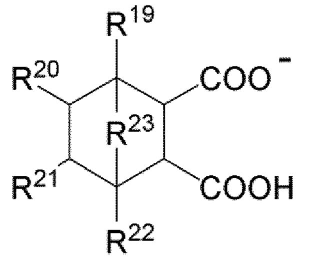

(10)

wherein $R^{19}$ to $R^{22}$ are identical or different and each represent a hydrogen atom or a $C_{1-4}$ alkyl group, and $R^{23}$ represents a methylene group or an ethylene group.

The $C_{1-4}$ alkyl group represented by $R^{19}$ to $R^{22}$ in formula (10) is preferably a linear or branched $C_{1-4}$ alkyl group. This alkyl group includes methyl, ethyl, n-propyl, isopropyl, n-butyl, isobutyl, sec-butyl, and tert-butyl. Of these, methyl is preferable.

$R^{19}$ to $R^{22}$ in formula (10) are identical or different and are preferably a hydrogen atom or methyl.

Formula (10) preferably represents an alicyclic dicarboxylic acid anion wherein $R^{23}$ is a methylene group and $R^{19}$ to $R^{22}$ are all a hydrogen atom (1); an alicyclic dicarboxylic acid anion wherein $R^{23}$ is a methylene group and any one of $R^{19}$ to $R^{22}$ is a methyl group with the remaining three groups being a hydrogen atom (2); or a mixture thereof.

Specific examples of the alicyclic dicarboxylic acid anion (10) include a hydrogenated nadic acid anion (a bicyclo[2.2.1]heptane-2,3-dicarboxylic acid anion) and a hydrogenated methyl nadic acid anion (a methylbicyclo[2.2.1] heptane-2,3-dicarboxylic acid anion). The alicyclic dicarboxylic acid anion (10) may also be a mixture of these anions.

Examples of the organic anion ($Z^-$) containing the structure represented by formula (5) include a cyclohexane dicarboxylic acid anion represented by formula (11)

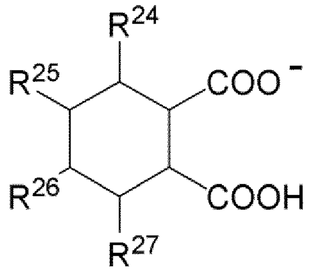

(11)

wherein $R^{24}$ to $R^{27}$ are identical or different and each represent a hydrogen atom or a $C_{1-4}$ alkyl group.

In formula (11), the $C_{1-4}$ alkyl group represented by $R^{24}$ to $R^{27}$ is preferably a linear or branched $C_{1-4}$ alkyl group. This alkyl group includes methyl, ethyl, n-propyl, isopropyl, n-butyl, isobutyl, sec-butyl, and tert-butyl. Of these, methyl is preferable.

$R^{24}$ to $R^{27}$ in formula (11) are identical or different and each preferably represent a hydrogen atom or methyl.

Examples of the cyclohexane dicarboxylic acid anion include a cyclohexane dicarboxylic acid anion wherein $R^{24}$ to $R^{27}$ in formula (11) are all a hydrogen atom, and a methyl cyclohexane dicarboxylic acid anion wherein any one of $R^{24}$ to $R^{27}$ is a methyl group with the remaining three groups being a hydrogen atom.

Specific examples include a cyclohexane dicarboxylic acid anion, a 3-methyl cyclohexane dicarboxylic acid anion, and a 4-methyl cyclohexane dicarboxylic acid anion.

Examples of the organic anion ($Z^-$) containing the structure represented by formula (5) include an organic sulfonic acid anion represented by formula (12)

$$R^{28}\text{-}SO_3^- \qquad (12)$$

wherein $R^{28}$ represents a $C_{1-18}$ alkyl group.

The $C_{1-18}$ alkyl group represented by $R^{28}$ in formula (12) is preferably a linear or branched $C_{1-18}$ alkyl group, and more preferably a linear or branched $C_{1-12}$ alkyl group. These alkyl groups include methyl, ethyl, n-propyl, isopropyl, n-butyl, isobutyl, sec- butyl, tert-butyl, n-pentyl, isopentyl, sec-pentyl, tert-pentyl, neopentyl, n-hexyl, isohexyl, sec-hexyl, tert-hexyl, neohexyl, n-heptyl, n-octyl, 2-ethylhexyl, n-nonyl, isononyl, n-decyl, isodecyl, and n-dodecyl. Of these, methyl is preferable.

Specific examples of the organic sulfonic acid anion represented by formula (12) include a methanesulfonic acid anion, an ethanesulfonic acid anion, a 1-propanesulfonic acid anion, a 2-propanesulfonic acid anion, a 1-butanesulfonic acid anion, a 1-pentanesulfonic acid anion, a 1-hexanesulfonic acid anion, a 1-octanesulfonic acid anion, a 1-decanesulfonic acid anion, and a 1-dodecanesulfonic acid anion. Of these, a methanesulfonic acid anion is preferable.

Examples of the organic anion ($Z^-$) containing the structure represented by formula (5) include an aromatic sulfonic acid anion represented by formula (13)

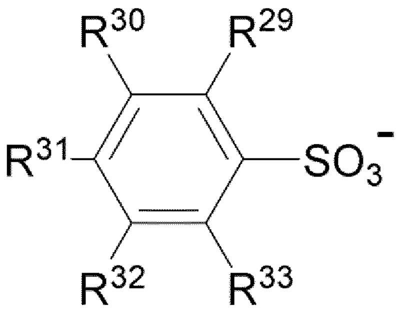 (13)

wherein $R^{29}$ to $R^{33}$ are identical or different and each represent a hydrogen atom, a $C_{1-18}$ alkyl group, a $C_{1-10}$ alkoxy group, or a halogen atom.

In formula (13), the $C_{1-18}$ alkyl group represented by $R^{29}$ to $R^{33}$ is preferably a linear or branched $C_{1-18}$ alkyl group. This alkyl group includes methyl, ethyl, n-propyl, isopropyl, n-butyl, isobutyl, sec-butyl, tert-butyl, n-pentyl, isopentyl, sec-pentyl, tert-pentyl, neopentyl, n-hexyl, isohexyl, sec-hexyl, tert-hexyl, neohexyl, n-heptyl, n-octyl, 2-ethylhexyl, n-nonyl, isononyl, n-decyl, isodecyl, and n-dodecyl. Of these, methyl and n-dodecyl are preferable.

In formula (13), the $C_{1-10}$ alkoxy group represented by $R^{29}$ to $R^{33}$ includes methoxy, ethoxy, and propoxy. Of these, methoxy and ethoxy are preferable.

In formula (13), examples of the halogen atom represented by $R^{29}$ to $R^{33}$ include a fluorine atom, a chlorine atom, a bromine atom, and an iodine atom, with a chlorine atom being preferable.

Specific examples of the aromatic sulfonic acid anion represented by formula (13) include a benzene sulfonic acid anion, a monoalkyl benzene sulfonic acid anion, a dialkyl benzene sulfonic acid anion, a monoalkoxy benzene sulfonic acid anion, and a mono-halobenzene sulfonic acid anion.

Examples of the monoalkyl benzene sulfonic acid anion include a 2-, 3-, or 4-mono- (linear or branched $C_{1-18}$ alkyl) benzene sulfonic acid anion, specifically a p-toluene sulfonic acid anion, a 4-ethyl benzene sulfonic acid anion, a 3- (linear or branched octyl) benzene sulfonic acid anion, a 4- (linear or branched octyl) benzene sulfonic acid anion, a 3- (linear or branched dodecyl) benzene sulfonic acid anion, and a 4- (linear or branched dodecyl) benzene sulfonic acid anion.

Examples of the dialkyl benzene sulfonic acid anion include di- (linear or branched $C_{1-12}$ alkyl) benzene sulfonic acid anion, specifically a 2,4-dimethyl benzene sulfonic acid anion and a 2,5-dimethyl benzene sulfonic acid anion.

Examples of the monoalkoxy benzene sulfonic acid anion include mono- (linear or branched $C_{1-6}$ alkoxy) benzene sulfonic acid anion, specifically a 4-methoxy benzene sulfonic acid anion and a 4-ethoxy benzene sulfonic acid anion.

Examples of the mono-halobenzene sulfonic acid anion include a 4-chlorobenzene sulfonic acid anion.

Of the examples listed above, a benzene sulfonic acid anion, a p-toluene sulfonic acid anion, a 4-chlorobenzene sulfonic acid anion, an n-dodecyl benzene sulfonic acid anion, and a branched dodecyl benzene sulfonic acid anion are preferable.

Examples of the organic anion ($Z^-$) containing the structure represented by formula (5) or formula (6) include an organophosphorus anion represented by formula (14)

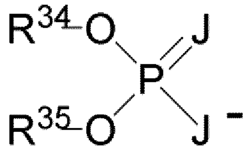 (14)

wherein $R^{34}$ and $R^{35}$ are identical or different and each represent a $C_{1-18}$ alkyl group, and J represents an oxygen atom or a sulfur atom.

In formula (14), the $C_{1-18}$ alkyl group represented by $R^{34}$ and $R^{35}$ is preferably a linear or branched $C_{1-18}$ alkyl group. This alkyl group includes methyl, ethyl, n-propyl, isopropyl, n-butyl, isobutyl, sec-butyl, tert-butyl, n-pentyl, isopentyl, sec-pentyl, tert-pentyl, neopentyl, n-hexyl, isohexyl, sec-hexyl, tert-hexyl, neohexyl, n-heptyl, n-octyl, 2-ethylhexyl, n-nonyl, isononyl, n-decyl, isodecyl, and n-dodecyl. Of these, methyl and ethyl are preferable.

Specific examples of the organophosphorus anion represented by formula (14) include a dimethyl phosphate anion, a diethyl phosphate anion, an O,O-dimethyl dithiophosphate anion, and an O,O-diethyl dithiophosphate anion. Of these, a dimethyl phosphate anion and an O,O-diethyl dithiophosphate anion are preferable.

Examples of the organic anion ($Z^-$) containing the structure represented by formula (7) includes an aromatic boron anion represented by formula (15)

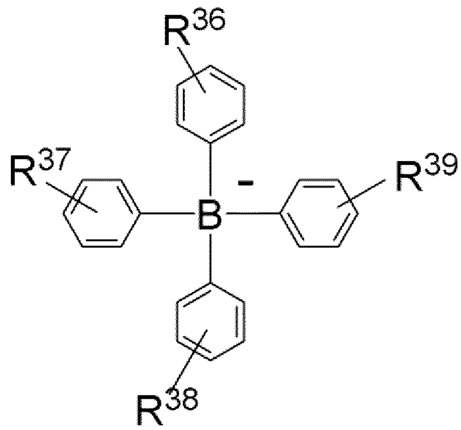

(15)

wherein $R^{36}$ to $R^{39}$ are identical or different and each represent a hydrogen atom, a $C_{1-18}$ alkyl group, a $C_{1-10}$ alkoxy group, or a halogen atom.

In formula (15), $R^{36}$ to $R^{39}$ are identical or different and each preferably represent a hydrogen atom or a $C_{1-18}$ alkyl group.

In formula (15), the $C_{1-18}$ alkyl group represented by $R^{36}$ to $R^{39}$ are preferably a linear or branched $C_{1-18}$ alkyl group. This alkyl group includes methyl, ethyl, n-propyl, isopropyl, n-butyl, isobutyl, sec-butyl, tert-butyl, n-pentyl, isopentyl, sec-pentyl, tert-pentyl, neopentyl, n-hexyl, isohexyl, sec-hexyl, tert-hexyl, neohexyl, n-heptyl, n-octyl, 2-ethylhexyl, n-nonyl, isononyl, n-decyl, isodecyl, and n-dodecyl. Of these, methyl is preferable.

In formula (15), the $C_{1-10}$ alkoxy group represented by $R^{36}$ to $R^{39}$ includes methoxy, ethoxy, and propoxy. Of these, methoxy and ethoxy are preferable.

In formula (15), examples of the halogen atom represented by $R^{36}$ to $R^{39}$ include a fluorine atom, a chlorine atom, a bromine atom, and an iodine atom, with a chlorine atom being preferable.

Specific examples of the aromatic boron anion represented by formula (15) include a tetraphenylboron anion or a tetra(4-methylphenyl)boron anion.

Examples of the organic anion ($Z^-$) containing the structure represented by formula (8) include a benzotriazole anion represented by formula (16)

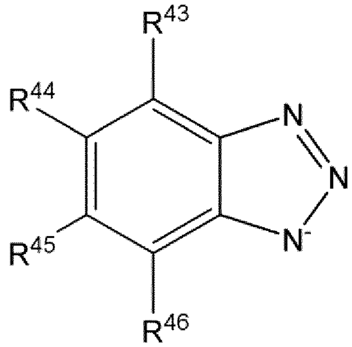

(16)

wherein $R^{43}$ to $R^{46}$ are identical or different and each represent a hydrogen atom or a $C_{1-4}$ alkyl group.

In formula (16), $R^{43}$ to $R^{46}$ are preferably a hydrogen atom.

In formula (16), the $C_{1-4}$ alkyl group represented by $R^{43}$ to $R^{46}$ is preferably a linear or branched $C_{1-4}$ alkyl group. Examples of this alkyl group include methyl, ethyl, n-propyl, isopropyl, n-butyl, isobutyl, sec-butyl, and tert-butyl. Of these, methyl and ethyl are preferable.

Specific examples of the benzotriazole anion represented by formula (16) include a benzotriazole anion.

For the organic anion ($Z^-$) in the phosphonium compound represented by formula (2), the following may be used singly or in a combination of two or more: the aliphatic monocarboxylic acid anion, alicyclic dicarboxylic acid anion, cyclohexane dicarboxylic acid anion, organic sulfonic acid anion, aromatic sulfonic acid anion, organophosphorus anion, aromatic boron anion, and benzotriazole anion described above.

Specific examples of the phosphonium compound (C) include tetrabutylphosphonium n-decanoate, tetrabutylphosphonium laurate, tetrabutylphosphonium myristate, tetrabutylphosphonium palmitate, a salt of a tetrabutylphosphonium cation and a bicyclo[2.2.1]heptane-2,3-dicarboxylic acid monoanion, a salt of a tetrabutylphosphonium cation and an anion mixture of a bicyclo[2.2.1]heptane-2,3-dicarboxylic acid monoanion and a methyl bicyclo[2.2.1]heptane-2,3-dicarboxylic acid monoanion, tetrabutylphosphonium methanesulfonate, tetrabutylphosphonium benzenesulfonate, tetrabutylphosphonium toluenesulfonate, tetrabutylphosphonium 4-chlorobenzenesulfonate, tetrabutylphosphonium n-dodecyl benzenesulfonate, tetrabutylphosphonium diethyl phosphodithionate, tetrabutylphosphonium tetraphenylborate, tetrabutylphosphonium tetra-p-tolylborate, and tetrabutylphosphonium benzotriazolate. Of these, tetrabutylphosphonium laurate, tetrabutylphosphonium diethyl phosphodithionate, and tetrabutylphosphonium tetra-p-tolylborate are listed, with tetrabutylphosphonium diethyl phosphodithionate being preferable.

A phosphonium compound alone can be used as a cure accelerator for epoxy resin. In a preferable embodiment, a mixture of a polycarboxylic anhydride (curing agent) and a phosphonium compound can be used for a curing agent for epoxy resin.

These phosphonium compounds may be used singly or in a suitable combination of two or more.

## Epoxy Resin Composition

The epoxy resin composition according to the present invention comprises an epoxy resin (A), a polycarboxylic anhydride (B), and a phosphonium compound (C).

The ratio of acid anhydride groups in the polycarboxylic anhydride (B) to one epoxy group of the epoxy resin (A) in the polycarboxylic anhydride (an equivalent ratio: acid anhydride groups/epoxy groups) is not particularly limited and is, for example, 0.8 to 1.2, and preferably 0.9 to 1.1.

The amount of the phosphonium compound (C) in the epoxy resin composition according to the present invention is not particularly limited as long as the amount falls within the range in which its cure-accelerating action on the epoxy resin is brought about. For example, the amount of the phosphonium compound (C) is 0.1 to 5 parts by weight, and preferably 0.5 to 2 parts by weight, per 100 parts by weight of the epoxy resin (A). The cure-accelerating action is provided by adding the phosphonium compound (C) in an amount of 0.1 parts by weight or more, and the curing time is further shortened by adding the phosphonium compound (C) in an amount of 0.5 parts by weight or more.

The epoxy resin composition according to the present invention may optionally suitably contain various additives that are widely used in the technical field to which the present invention pertains, to such an extent that the effects of the present invention are not impaired. Examples of such additives include an ultraviolet absorber, an antioxidant agent, a light stabilizer, a pigment, a dye, a filler, a flame-retarding agent, a flow-regulating agent, a leveling agent, a surface tension adjuster, a tackifier, a coupling agent, a defoaming agent, an antistatic agent, and a solvent.

When these additives are used, the amount may be within the typical range in use as long as the effects of the present invention are not impaired. The amount is, for example, 10 parts by weight or less per 100 parts by weight of the sum of the epoxy resin (A), the polycarboxylic anhydride (B), and the phosphonium compound (C).

The epoxy resin composition according to the present invention may be produced by mixing and stirring the predetermined amounts of the epoxy resin (A), the polycarboxylic anhydride (B), and the phosphonium compound (B), optionally with additives, by using a known means.

Each component (i.e., the epoxy resin (A), the polycarboxylic anhydride (B), the phosphonium compound (C), and additives) may be added at one time, or gradually added in several portions.

The additives may be added and mixed at any stage; for example, the additives may be mixed at the time the polycarboxylic anhydride (B) is mixed with the phosphonium compound (C), before the epoxy resin (A) is added, at the time the epoxy resin (A) is added, or after the epoxy resin (A) is added.

The polycarboxylic anhydride itself does not volatilize. Thus, when the polycarboxylic anhydride is added to an epoxy resin and cured by heating, the formulation balance of the resin composition remains stable.

## Epoxy Resin Molded Article (Cured Epoxy Resin Product)

The epoxy resin molded article (which may be hereinafter referred to as "cured epoxy resin product") of the present invention is produced from an epoxy resin composition containing the epoxy resin (A), the polycarboxylic anhydride (B), and the phosphonium compound (C), optionally with additives.

The epoxy resin molded article obtained from the epoxy resin composition of the present invention has a high

glass-transition temperature (Tg), as well as excellent initial transparency, weatherability, adhesion, and water vapor barrier properties. The epoxy resin composition of the present invention is thus suitable for forming, in particular, a thin film that requires to be cured at a relatively high temperature.

Examples of the method for producing a thin film from the epoxy resin composition of the present invention include a method in which the composition is applied to a substrate, and the coated film is cured to form a thin film (in particular, a thin film with a thickness of 1 mm or less). The film thickness is preferably about 0.3 mm or less. The lower limit of the film thickness is typically about 0.001 mm.

The epoxy resin composition according to the present invention is usable with various types of substrates and can be applied onto any type of substrate. Examples of the substrate include glass, ceramics, aluminum, CCLs (copper-clad laminates), and heat-resistant polymers, such as polyethylene terephthalate (PET), polycarbonate (PC), polyimide (PI), and acrylonitrile butadiene styrene copolymer (ABS). The shape of the substrate is not particularly limited, and the substrate may be in the form of film or sheet, for example.

The method for applying the epoxy resin composition of the present invention onto a substrate is not particularly limited, and any known methods may be used without limitation. Examples include known methods, such as screen printing, and methods using a die coater, a comma coater, a roll coater, a bar coater, a gravure coater, a curtain coater, a spray coater, an air-knife coater, a reverse coater or a dip-squeeze coater.

The method for curing a coated film is not particularly limited, and known methods may be used. For curing, known curing equipment may be used, such as a closed curing furnace or a tunnel furnace capable of performing continuous curing. For heating, a known method may be used, such as hot-air circulation, infrared heating, or high-frequency heating.

Curing may be typically performed at a temperature of about 120 to 200°C for about 5 minutes to 5 hours. In particular, curing is preferably performed at about 120 to 180°C for about 10 minutes to 3 hours.

When value is placed on its transparency in applications of the epoxy resin molded article of the present invention, the article preferably has a high transmittance in the wavelength range from visible light to near-ultraviolet light. The initial transparency of the epoxy resin molded article (cured epoxy product) can be evaluated by measuring the yellow index (YI) after the epoxy resin composition has been cured. YI represents the degree of yellowness of the epoxy resin molded article (cured epoxy product). The smaller the value, the higher the colorlessness and transparency; the larger the value, the higher the degree of yellowness. YI is preferably within the range of -0.5 to 3, and more preferably -0.5 to 2. The yellow index is a value determined by the method described in the Examples below.

The weatherability of the epoxy resin molded article of the present invention can be comprehensively evaluated from the weather-yellowing resistance and weather-crack resistance after a weatherability test.

The weather-yellowing resistance (ΔYI) can be evaluated from the difference between YI after the weatherability test and the initial transparency (YI). The smaller the ΔYI value, the higher the weather-yellowing resistance. The ΔYI is preferably within the range of -0.5 to 15, more preferably -0.5 to 7, and particularly preferably -0.5 to 1. The yellow indexes before the weatherability test and after the weatherability test are values determined by the method described in the Examples below.

The weather-crack resistance can be evaluated based on the change in appearance after the weatherability test (whether cracks are present), and having no cracks is preferable. The weather-crack resistance was evaluated by the method described in the Examples below.

The adhesion of the epoxy resin molded article of the present invention means adhesion of the epoxy resin molded article to various substrates (steel plates, PC, PET, PI, copper plates), and can be evaluated in terms of adhesion, adhesion in boiling water, moist-heat-resistant adhesion, and moist-heat-resistant flexibility; preferably no peeling is observed in any case. The adhesion, adhesion in boiling water, moist-heat-resistant adhesion, and moist-heat-resistant flexibility were evaluated by the methods described in the Examples below.

The heat resistance of the epoxy resin molded article of the present invention can be evaluated from the glass-transition temperature (°C) of the cured epoxy product. The glass-transition temperature (°C) is preferably 80 to 200°C, and more preferably 100 to 200°C. The glass-transition temperature is a value determined by the method described in the Examples below.

The water vapor barrier properties of the epoxy resin molded article of the present invention can be evaluated from the water vapor transmission rate of the cured epoxy resin product. The smaller the water vapor transmission rate, the better the water vapor barrier properties. The water vapor transmission rate is preferably within the range of 1 to 30, more preferably 1 to 20, and particularly preferably 1 to 10.

## Use

The epoxy resin composition and epoxy resin molded article of the present invention can be used in a variety of fields in which thermosetting resins can be used. Examples include adhesive materials, coating compositions, ink, toner, coating materials, molding materials (including, for example, seats, films, and FRP), electrically insulating materials

(including, for example, printed circuit boards and wire covering), semiconductor-sealing materials, resist materials, plasticizers, lubricants, fiber treatment agents, surfactants, medicines, and agrichemicals.

Because of its excellent initial transparency, weatherability, adhesion to substrates, heat resistance, and water vapor barrier properties, this epoxy resin molded article can be suitably used for various glass substrates; automotive parts (in particular, glazing materials); or transparent hard coating materials for display devices, such as liquid crystal displays and plasma displays. It is important for a liquid crystal display to be resistant to yellowing caused by high heat of the backlight. Thus, the epoxy resin composition of the present invention can be suitably used as a coating material for liquid crystal displays. As described here, the epoxy resin molded article of the present invention is also useful as a coating material for displays.

## Examples

The following describes the present invention in more detail with reference to Examples. However, the present invention is not limited to the Examples. The properties described in the Examples and Comparative Examples were each measured in accordance with the methods described below. For the compounds that are not detailed here, reagents were used. The compounds used in Production Examples 1 to 3, Examples 1 to 25, and Comparative Examples 1 to 19, their abbreviated names, and substrates are shown below.

### Compound Abbreviations, Compounds, and Substrates Used Acid Anhydride

- HH: Rikacid HH, hexahydrophthalic anhydride (produced by New Japan Chemical Co., Ltd.)
- MH-T: Rikacid MH-T, 4-methylhexahydrophthalic anhydride (produced by New Japan Chemical Co., Ltd.)

### Alcohol

- HB: Rikabinol HB, hydrogenated bisphenol A (produced by New Japan Chemical Co., Ltd.)
- 27-DH: decahydro-2,7-naphthalene diol (produced by Sugai Chemical Industory Co., Ltd.)

### Epoxy Resin

- jER828: jER828, bisphenol A-type epoxy resin (epoxy equivalent 185, produced by Mitsubishi Chemical Corporation)
- YX-8000: jER YX-8000, hydrogenated bisphenol A diglycidyl ether-type epoxy resin (epoxy equivalent 204, produced by Mitsubishi Chemical Corporation)
- HBE-100: Rikaresin HBE-100, hydrogenated bisphenol A diglycidyl ether-type epoxy resin (epoxy equivalent 215, produced by New Japan Chemical Co., Ltd.)
- TEPIC-L: TEPIC-L, triazine epoxy resin (epoxy equivalent 99, produced by Nissan Chemical Industries, Ltd.)
- TEPIC-VL: TEPIC-VL, triazine epoxy resin (epoxy equivalent 126, produced by Nissan Chemical Industries, Ltd.)
- TEPIC-PAS: TEPIC-PAS, triazine epoxy resin (epoxy equivalent 137, produced by Nissan Chemical Industries, Ltd.)
- MA-DGIC: MA-DGIC, 1-allyl-3,5-bis(2,3-epoxypropan-1-yl)-1,3,5-triazine-2,4,6(1H,3H,5H)-trione, triazine epoxy resin (epoxy equivalent 141, produced by Shikoku Chemicals Corporation.)
- TG-G: TG-G, 1,3,4,6-tetraglycidyl glycoluril, glycoluril-type epoxy resin (epoxy equivalent 92, produced by Shikoku Chemicals Corporation.)
- jER152: jER 152, phenol novolac-type epoxy resin (epoxy equivalent 174, produced by Mitsubishi Chemical Corporation)
- N-660: EPICLON N-660, cresol novolac-type epoxy resin (epoxy equivalent 205, ADEKA Corporation)

### Curing Agent

- MH-T: Rikacid MH-T, 4-methylhexahydrophthalic anhydride (produced by New Japan Chemical Co., Ltd.)
- MH-700: Rikacid MH-700, a mixture of 4-methylhexahydrophthalic anhydride and hexahydrophthalic anhydride

(weight ratio 7:3) (produced by New Japan Chemical Co., Ltd.)

- HNA-100: Rikacid HNA-100, a mixture of hydrogenated nadic anhydride and hydrogenated methyl nadic anhydride (weight ratio 1:4) (produced by New Japan Chemical Co., Ltd.)
- FXJ-8077: Fujicure FXJ-8077, produced by T&K TOKA., Ltd.

Cure Accelerator

- PX-4ET: Hishicolin PX-4ET, tetrabutylphosphonium diethyl phosphodithionate (produced by Nippon Chemical Industrial Co., Ltd.)
- TPP-MK: TPP-MK, tetraphenylphosphonium tetra-p-tolylborate (produced by Hokko Chemical Industry Co., Ltd.)
- TBPDA: TBPDA, tetrabutylphosphonium n-decanoate (produced by Hokko Chemical Industry Co., Ltd.)
- PX-4MP: Hishicolin PX-4MP, methyl tributyl phosphonium dimethyl phosphate (produced by Nippon Chemical Industrial Co., Ltd.)
- PX-4BT: Hishicolin PX-4BT, tetrabutylphosphonium benzotriazolate
- TBP-HH: tetrabutylphosphonium hexahydrophthalate (produced in accordance with the method described in Production Example 1 of JP2008-179733A)
- TBP-MS: tetrabutylphosphonium methanesulfonate (produced in accordance with the method described in Production Example 1 of JP2010-106131A)
- TBP-HNA: a tetrabutylphosphonium salt of a mixture of hydrogenated nadic acid and hydrogenated methyl nadic acid (weight ratio 1:4), (produced in accordance with the method described in Production Example 1 of JP2008-179733A)
- TBP-BS: tetrabutylphosphonium benzenesulfonate (produced in accordance with the method described in Production Example 2 of JP2010-106131A)
- TBP-BB: Hokko TBP-BB, tetrabutylphosphonium bromide (produced by Hokko Chemical Industry Co., Ltd.)
- TPP-PB: TPP-PB, tetraphenylphosphonium bromide (produced by Hokko Chemical Industry Co., Ltd.)
- DBU: 1,8-diazabicyclo[5.4.0]undec-7-ene (produced by San-Apro Ltd.)
- DMP-30: DMP-30: Luveak-DMP-30, 2,4,6-tris(dimethylaminomethyl)phenol (produced by Nacalai Tesque, Inc.)
- U-CAT5003: U-CAT 5003, tetraphenylphosphonium bromide (produced by San-Apro Ltd.)

Substrate

- Steel Plate: cold-rolled steel sheet (produced by Nippon Testpanel Co., Ltd.)
- PC: polycarbonate (produced by Sanshodo)
- PET: polyethylene terephthalate, Cosmoshine A4300 (produced by Toyobo Co., Ltd.)
- PI: polyimide, Kapton 100EN (produced by Du Pont-Toray Co., Ltd.)
- Copper Plate: Hull cell cathode plate (produced by Yamamoto-MS Co., Ltd.)

Analysis of Polycarboxylic Anhydride

Number Average Molecular Weight

About 0.1 g of a polycarboxylic anhydride solution was dissolved in 2 ml of tetrahydrofuran to prepare a sample solution for measuring the molecular weight. The number average molecular weight (Mn) on a polystyrene basis was determined by gel permeation chromatography (GPC) under the following measurement conditions.

Measurement Conditions

Device: a pump (LC-20AD produced by Shimadzu Corporation), a column (Shodex KF-801, Shodex KF-802, and Shodex KF-804, all produced by Showa Denko K.K.), a detector (RID-10A produced by Shimadzu Corporation)
Eluent: tetrahydrofuran
Column temperature 40°C, flow rate 1.0 mL/min

Volatility during Heating

The solvent of the polycarboxylic anhydride solution was completely distilled off at 120°C at a reduced pressure of 0.7 kPa for 30 to 40 minutes. After distilling off the solvent, 0.10 g of the obtained polycarboxylic anhydride was placed on a metal plate with a diameter of 40 mm and heated at 180°C for 1 hour. The volatility during heating was measured based on the weight change before and after heating. The volatility during heating was calculated using the following equation (1). A smaller value of volatility during heating indicates being less volatile.

$$\text{Volatility during Heating (\%)} = (W_2 - W_1) \times 100/W_1 \quad (1)$$

$W_1$: Weight (g) of polycarboxylic anhydride before heating
$W_2$: Weight (g) of polycarboxylic anhydride after heating

Acid Anhydride Equivalent

3.00 g of a polycarboxylic anhydride solution was placed in an Erlenmeyer flask, and 10 mL of pyridine was added for dissolution. 50 mL of ion-exchanged water was further added and heated under reflux for 3 hours, and the resulting product was allowed to cool to room temperature (25°C). After cooling, 5 droplets of a 1 wt% phenolphthalein solution were added, and the mixture was titrated with a 0.5M potassium hydroxide ethanol solution. The time point at which coloration was maintained for 30 seconds was determined to be the endpoint. The acid anhydride equivalent was calculated using the following equation (2). The acid anhydride equivalent (g/eq) expresses the mass of the polycarboxylic anhydride solution containing 1 mol of acid anhydride group in grams.

$$\text{Acid Anhydride Equivalent} = (B \times 2 \times 10^3)/(A \times N) \quad (2)$$

A: 0.5M potassium hydroxide ethanol solution used in the titration (ml)
B: Sample amount (g)
N: Normality of the potassium hydroxide ethanol solution

Method for Evaluating Physical Properties of Cured Epoxy Resin Product

Initial Transparency

An epoxy resin composition (solution) was poured into a metallic dish (about 4 cm in diameter) covered with aluminum foil such that the epoxy resin composition after being cured had a thickness of 100 μm, and the solvent was dried at 100°C for 10 minutes, followed by curing at 150°C for 2 hours. With the aluminum foil attached on one side of the specimen, the reflectance of the specimen was measured with a spectrophotometer (CM-5 spectrophotometer produced by Konica Minolta, Inc.). The YI was calculated based on the reflectance in accordance with ASTM D1925-70 (reapproved 1988). The YI represents the degree of yellowness of the cured film (cured epoxy resin product). A larger YI value indicates a higher degree of yellowness. When a measurement object is nearly colorless and transparent, this value is close to 0.

Weatherability

Weather-Yellowing Resistance

An epoxy resin composition solution was poured into a metallic dish (about 4 cm in diameter) covered with aluminum foil such that the epoxy resin composition after being cured had a thickness of 100 μm, and the solvent was dried at 100°C for 10 minutes, followed by curing at 150°C for 2 hours. With the aluminum foil attached on one side of the specimen, the specimen was exposed for 500 hours in accordance with JIS K 7350-2 (ver. November 20, 2008) and taken out, followed by measurement of the reflectance with a spectrophotometer (CM-5 spectrophotometer produced by Konica Minolta, Inc.). The YI was calculated based on the reflectance in accordance with ASTM D1925-70 (reapproved 1988). The YI values before and after the cured film (cured epoxy resin product) was subjected to the weatherability test were measured, and the difference between these values was determined to be the weather-yellowing resistance (ΔYI). A smaller ΔYI value indicates a higher weather-yellowing resistance of the cured film.

Weather-Crack Resistance

The appearance after the weatherability test (whether cracks are present) was evaluated in accordance with the following criteria.

A: No cracks appeared.
B: A crack appeared.

Adhesion

An epoxy resin composition (solution) was applied onto the following substrates, a steel plate, a PC plate, a copper plate (300 μm), a PET plate (250 μm), and a PI plate (100 μm), and the solvent was dried at 100°C for 10 minutes, followed by curing at 130 to 150°C for 2 hours, thereby preparing cured coating films with a thickness of 30 μm (cured epoxy resin product). A cross-cut test was performed on the cured coating films on the substrates in accordance with JISK5600-5-6 (ver. April 20, 1999). When cellophane adhesive tape was peeled off, each cured coating film was visually observed for evaluation. The evaluation criteria are as follows.

A: No peeling of the cured coating film was observed.
B: Peeling of the cured coating film was observed.

Adhesion in Boiling Water

Cured coating films (cured epoxy resin products) prepared in the same manner as for the substrates for measuring adhesion were immersed in distilled water at 100°C for 1 hour, and then the appearance was visually observed for evaluation of the adhesion in the same manner as above (adhesion).

Moist-heat-resistant Adhesiveness

Cured coating films (cured epoxy resin products) prepared in the same manner as for the substrates for measuring adhesion were allowed to stand under constant temperature and humidity conditions (85°C, 85% RH) for 500 hours in a small environmental test chamber (SH661 produced by Espec Corp.). The appearance was then visually observed for evaluation of the adhesion in the same manner as above (adhesion).

Moist-heat-resistant Flexibility

Cured coating films (cured epoxy resin products) prepared in the same manner as for the substrates for measuring adhesion were allowed to stand under constant temperature and humidity conditions (85°C, 85% RH) for 500 hours in a small environmental test chamber (SH661 produced by Espec Corp.). Each substrate was then bent to a 90° or 180° angle, and the cured coating film at the portion at which the substrate was bent was visually observed and evaluated. The evaluation criteria are as follows.

A: No change was observed in appearance.
B: Lifting or peeling was observed in appearance.

Glass-transition Temperature

An epoxy resin composition (solution) was poured into a metallic dish (about 4 cm in diameter) covered with aluminum foil such that the epoxy resin composition after being cured had a thickness of 100 μm, and the solvent was dried at 100°C for 10 minutes, followed by curing at 150°C for 2 hours. The aluminum foil was removed from the cured product, and the product was measured with a differential scanning calorimeter (DSC6220 produced by SII NanoTechnology Inc.) under the following measurement condition. The inflection point measured was determined to be the glass-transition temperature (°C). A higher glass-transition temperature indicates a higher heat resistance. Measurement Condition: measurement was performed while the temperature was increased from -20°C to 200°C at 20°C/min.

Water Vapor Barrier Properties

An epoxy resin composition (solution) (containing 0.1% of a silicon mold release agent) was applied to a glass plate, and the solvent was dried at 100°C for 10 minutes, followed by curing at 150°C for 2 hours, thereby preparing a

cured coating film (cured epoxy resin product). The obtained cured coating film product was immersed in distilled water at 100°C for 30 minutes and peeled off from the glass plate. The water vapor transmission rate (g·2Spm/$m^2$·24h·atm) of the removed 10-μm to 20-μm film was measured at 40°C/90 RH% in accordance with JIS K7129-C (differential pressure GC method) with a water vapor transmission measurement device (GTR-XACT produced by GTR Tec Corporation.). A smaller water vapor transmission rate indicates better water vapor barrier properties.

Production Examples of Polycarboxylic Anhydride

Production Example 1

22.5 g of HH (146.0 mmol, which is twice HB in mmol) was added to a solution of 17.6 g of HB (73.0 mmol) in 15.0 g of butyl acetate, and the resulting product was stirred at 110°C for 3 hours under a nitrogen stream, thereby obtaining a solution of a dicarboxylic acid compound (HB/HH) in butyl acetate. 26.1 g of acetic anhydride (255.5 mmol, which is 3.5 times the HB in mmol) was added to this dicarboxylic acid compound solution and stirred at 100°C for 1 hour under a nitrogen stream. Subsequently, the pressure inside the reactor was gradually reduced to 10.7 to 13.3 kPa, and the solvent was added dropwise to the reactor and distilled off (butyl acetate was dropped and distilled off at a rate of 60 mL/h) to allow a reaction to proceed for 5 hours, thereby obtaining a polycarboxylic anhydride solution. Thereafter, the solution was diluted with butyl acetate to 40wt%, and a solution of polycarboxylic anhydride (HB/HH) in butyl acetate was prepared. The number average molecular weight, the volatility during heating, and the acid anhydride equivalent of the polycarboxylic anhydride were measured. Table 1 shows the results.

Production Example 2

A polycarboxylic anhydride solution was obtained in the same manner as in Production Example 1, except that 24.5 g of MH-T (146.0 mmol) was used in place of 22.5 g of HH (146.0 mmol). Thereafter, the solution was diluted with butyl acetate to 40 wt%, and a solution of polycarboxylic anhydride (HB/MH-T) in butyl acetate was prepared. The number average molecular weight, the volatility during heating, and the acid anhydride equivalent of the polycarboxylic anhydride were measured. Table 1 shows the results.

Production Example 3

A polycarboxylic anhydride solution was obtained in the same manner as in Production Example 1, except that 12.4 g of 27-DH (73.0 mmol) was used in place of 17.6 g of HB (73.0 mmol). Thereafter, the solution was diluted with butyl acetate to 40 wt%, and a solution of polycarboxylic anhydride (27-DH/HH) in butyl acetate was prepared. The number average molecular weight, the volatility during heating, and the acid anhydride equivalent of the polycarboxylic anhydride were measured. Table 1 shows the results.

For reference, the volatility during heating and the acid anhydride equivalent of MH-T, MH-700, and HNA-100 were measured. Table 1 shows the results.

Table 1

| | Polycarboxylic Anhydride | | | Reference | | |
|---|---|---|---|---|---|---|
| | HB/HH | HB/MH-T | 27-DH/HH | MH-T | MH-700 | HNA-100 |
| Number Average Molecular Weight (Mn) | 4700 | 3300 | 3400 | - | - | - |
| Volatility during Heating (%) | 0 | 0 | 0 | 99.3 | 99.3 | 99.2 |
| Acid Anhydride Equivalent (g/eq) | 1140 | 943 | 925 | 169 | 164 | 179 |

Example 1

jER828 (100 parts by weight) as an epoxy resin, a 40wt% polycarboxylic anhydride (HB/HH) solution (616 parts by weight) obtained in Production Example 1 as a polycarboxylic anhydride (curing agent), and PX-4ET (1 part by weight) as a phosphonium compound (cure accelerator) were mixed at room temperature for 15 minutes and then deaerated with a mixer (Awatori Rentaro, Thinky Corporation), thereby obtaining an epoxy resin composition (solution). The obtained epoxy resin composition (solution) was cured and then measured for the glass-transition temperature, weatherability test, adhesion test, moist-heat-resistant flexibility, and water vapor transmission rate. Table 2 shows the results.

Examples 2 to 12

Epoxy resins shown in Table 2, 40 wt% polycarboxylic anhydride solutions obtained in Production Examples 1 to 3 as polycarboxylic anhydride (curing agent), and phosphonium compounds (cure accelerator) shown in Table 2 were mixed in the same manner as in Example 1 at compositional ratios (parts by weight) shown in Table 2, thereby obtaining epoxy resin compositions (solutions). The obtained epoxy resin compositions (solution) were cured and then measured for the glass-transition temperature, weatherability test, adhesion test, moist-heat-resistant flexibility, and water vapor transmission rate. Table 2 shows the results.

Table 2

| | | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|---|
| Epoxy Resin Composition (Parts by Weight) | Epoxy Resin | jER828 | 100 | 100 | 100 | 100 | 100 | – | – | – | – | – | – | – |
| | | YX-8000 | – | – | – | – | – | 100 | – | – | – | – | – | – |
| | | HBE-100 | – | – | – | – | – | – | 100 | – | – | – | – | – |
| | | TEPIC-L | – | – | – | – | – | – | – | 100 | – | – | – | – |
| | | TEPIC-VL | – | – | – | – | – | – | – | – | 100 | – | – | – |
| | | TEPIC-PAS | – | – | – | – | – | – | – | – | – | 100 | – | – |
| | | jER152 | – | – | – | – | – | – | – | – | – | – | 100 | – |
| | | N-660 | – | – | – | – | – | – | – | – | – | – | – | 100 |
| | Polycarboxylic Anhydride (Curing Agent) | HB/HH | 616 | 616 | 616 | – | – | 559 | 530 | 1152 | 905 | 832 | 655 | 556 |
| | | HB/MH-T | – | – | – | 510 | | | | | | | | |
| | | 27-DH/HH | – | – | – | – | 500 | – | – | – | – | – | – | – |
| | Phosphonium Compound (Cure Accelerator) | PX-4ET | 1 | – | – | 1 | 1 | 1 | 1 | 1 | 1 | 1 | 1 | 1 |
| | | TPP-MK | – | 1 | – | – | – | – | – | – | – | – | – | – |
| | | TBPDA | – | – | 1 | – | – | – | – | – | – | – | – | – |
| Evaluation of Physical Properties of Cured Epoxy Product | Initial Transparency (YI) | | −0.2 | −0.1 | −0.1 | −0.1 | −0.1 | −0.02 | −0.1 | −0.07 | −0.1 | −0.1 | −0.1 | 0.03 |
| | Weatherability Test | Weather-yellowing Resistance (ΔYI) | 4.9 | 4.8 | 4.9 | 5.0 | 4.8 | −0.04 | −0.1 | −0.05 | −0.1 | −0.1 | 6.6 | 10.2 |
| | | Weather-crack Resistance | A | A | A | A | A | A | A | A | A | A | A | A |
| | Adhesion Test | Steel Plate | A | A | A | A | A | A | A | A | A | A | A | A |
| | | PC | A | A | A | A | A | A | A | A | A | A | A | A |
| | | PET | A | A | A | A | A | A | A | A | A | A | A | A |
| | | PI | A | A | A | A | A | A | A | A | A | A | A | A |
| | | Copper Plate | A | A | A | A | A | A | A | A | A | A | A | A |
| | Adhesion Test – Adhesion in Boiling Water | PC | A | A | A | A | A | A | A | A | A | A | A | A |
| | | PET | A | A | A | A | A | A | A | A | A | A | A | A |
| | | PI | A | A | A | A | A | A | A | A | A | A | A | A |
| | | Copper Plate | A | A | A | A | A | A | A | A | A | A | A | A |
| | Adhesion Test – Moist-heat-resistant Adhesion | PC | A | A | A | A | A | A | A | A | A | A | A | A |
| | | PET | A | A | A | A | A | A | A | A | A | A | A | A |
| | Adhesion Test – Moist-heat-resistant Flexibility | PC (bent to 90° angle) | A | A | A | A | A | A | A | A | A | A | A | A |
| | | PET (bent to 180° angle) | A | A | A | A | A | A | A | A | A | A | A | A |
| | Glass-transition Temperature (°C) | | 125 | 125 | 122 | 120 | 128 | 118 | 115 | 136 | 135 | 135 | 132 | 130 |
| | Water Vapor Transmission Rate | | 4.0 | 4.0 | 4.0 | 4.2 | 4.0 | 4.0 | 4.0 | 4.0 | 3.5 | 3.3 | 3.2 | 3.3 |

Examples 13 to 25

Epoxy resins shown in Table 3, 40 wt% polycarboxylic anhydride solutions obtained in Production Examples 1 to 3 as polycarboxylic anhydride (curing agent), and phosphonium compounds (cure accelerator) shown in Table 3 were mixed in the same manner as in Example 1 at compositional ratios (parts by weight) shown in Example 3, thereby obtaining epoxy resin compositions (solutions). The obtained epoxy resin compositions (solution) were cured and then measured for the glass-transition temperature, weatherability test, adhesion test, moist-heat-resistant flexibility, and water vapor transmission rate. Table 3 shows the results.

Table 3

| | | | | Example 13 | Example 14 | Example 15 | Example 16 | Example 17 | Example 18 | Example 19 | Example 20 | Example 21 | Example 22 | Example 23 | Example 24 | Example 25 |
|---|---|---|---|---|---|---|---|---|---|---|---|---|---|---|---|---|
| Epoxy Resin Composition (Parts by Weight) | Epoxy Resin | | HBE-100 | 100 | 100 | 100 | 100 | 100 | 100 | 100 | 100 | 100 | 100 | – | – | – |
| | | | TEPIC-L | – | – | – | – | – | – | – | – | – | – | 100 | – | – |
| | | | MA-DGIC | – | – | – | – | – | – | – | – | – | – | – | 100 | – |
| | | | TG-G | – | – | – | – | – | – | – | – | – | – | – | – | 100 |
| | Polycarboxylic Anhydride (Curing Agent) | | HB/HH | 530 | 530 | 530 | 530 | 530 | 530 | 530 | 530 | – | – | 1152 | 809 | 1239 |
| | | | HB/MH-T | – | – | – | – | – | – | – | – | 439 | – | – | – | – |
| | | | 27-DH/HH | – | – | – | – | – | – | – | – | – | 430 | – | – | – |
| | Phosphonium Compound (Cure Accelerator) | | PX-4ET | – | – | – | – | – | – | – | – | 1 | 1 | – | 1 | 1 |
| | | | PX-4MP | 1 | – | – | – | – | – | – | – | – | – | 1 | – | – |
| | | | PX-4BT | – | 1 | – | – | – | – | – | – | – | – | – | – | – |
| | | | TPP-MK | – | – | 1 | – | – | – | – | – | – | – | – | – | – |
| | | | TBPDA | – | – | – | 1 | – | – | – | – | – | – | – | – | – |
| | | | TBP-HH | – | – | – | – | 1 | – | – | – | – | – | – | – | – |
| | | | TBP-MS | – | – | – | – | – | 1 | – | – | – | – | – | – | – |
| | | | TBP-HNA | – | – | – | – | – | – | 1 | – | – | – | – | – | – |
| | | | TBP-BS | – | – | – | – | – | – | – | 1 | – | – | – | – | – |
| Evaluation of Physical Properties of Cured Epoxy Product | Initial Transparency (YI) | | | −0.2 | −0.1 | −0.1 | −0.1 | 0.2 | 0.1 | 0.03 | 0.03 | −0.1 | −0.1 | −0.2 | −0.01 | 0.22 |
| | Weatherability Test | | Weather-yellowing Resistance (ΔYI) | 0.0 | 0.02 | 0.03 | 0.05 | 0.1 | 0.1 | 0.05 | 0.05 | 0.1 | 0.11 | 0.06 | 0.04 | 0.05 |
| | | | Weather-crack Resistance | A | A | A | A | A | A | A | A | A | A | A | A | A |
| | Adhesion Test | | Steel Plate | A | A | A | A | A | A | A | A | A | A | A | A | A |
| | | | PC | A | A | A | A | A | A | A | A | A | A | A | A | A |
| | | | PET | A | A | A | A | A | A | A | A | A | A | A | A | A |
| | | | PI | A | A | A | A | A | A | A | A | A | A | A | A | A |
| | | | Copper Plate | A | A | A | A | A | A | A | A | A | A | A | A | A |
| | | Adhesion in Boiling Water | PC | A | A | A | A | A | A | A | A | A | A | A | A | A |
| | | | PET | A | A | A | A | A | A | A | A | A | A | A | A | A |
| | | | PI | A | A | A | A | A | A | A | A | A | A | A | A | A |
| | | | Copper Plate | A | A | A | A | A | A | A | A | A | A | A | A | A |
| | | Moist-heat-resistant Adhesion | PC | A | A | A | A | A | A | A | A | A | A | A | A | A |
| | | | PET | A | A | A | A | A | A | A | A | A | A | A | A | A |
| | Moist-heat-resistant Flexibility | | PC (bent to 90° angle) | A | A | A | A | A | A | A | A | A | A | A | A | A |
| | | | PET (bent to 180° angle) | A | A | A | A | A | A | A | A | A | A | A | A | A |
| | Glass-transition Temperature (°C) | | | 116 | 114 | 115 | 115 | 115 | 116 | 116 | 116 | 117 | 119 | 135 | 124 | 139 |
| | Water Vapor Transmission Rate | | | 4.0 | 4.2 | 4.1 | 4.0 | 4.0 | 4.0 | 4.0 | 4.0 | 4.4 | 4.0 | 3.1 | 3.2 | 3.3 |

Comparative Example 1

MH-T (91 parts by weight) as a curing agent and TBP-BB (1 part by weight) as a cure accelerator were heated with stirring at 80°C for 15 minutes to dissolve the mixture and then cooled to room temperature. Thereafter, jER828 (100 parts by weight) as an epoxy resin was added thereto and mixed at room temperature for 15 minutes, followed by deaeration with a mixer (Awatori Rentaro, Thinky Corporation), thereby obtaining an epoxy resin composition (solution). The obtained epoxy resin composition (solution) was cured and then measured for the glass-transition temperature, weatherability test, adhesion test, moist-heat-resistant flexibility, and water vapor transmission rate. Table 4 shows the results. In Comparative Example 1, the test specimen markedly degraded after the weatherability test, and the reflectance thus could not be measured; thus, the YI value could not be determined. The water vapor transmission rate also could not be measured because the test specimen degraded during measurement.

Comparative Examples 2 to 11

The epoxy resins, curing agents, and cure accelerators shown in Table 4 were mixed at the compositional ratios shown in Table 4 (parts by weight) in the same manner as in Comparative Example 1, thereby obtaining epoxy resin compositions (solution). The obtained epoxy resin compositions (solution) were cured and then measured for the glass-transition temperature, weatherability test, adhesion test, moist-heat-resistant flexibility, and water vapor transmission rate. Table 4 shows the results. In Comparative Examples 2 to 11, the test specimens markedly degraded after the weatherability test, and the reflectance thus could not be measured; the YI values thus could not be determined. The water vapor transmission rates also could not be measured because the test specimens degraded during measurement.

Comparative Example 12

jER828 (100 parts by weight) as an epoxy resin and FXJ-8077 (35 parts by weight) as a curing agent were mixed at room temperature for 15 minutes and then deaerated with a mixer (Awatori Rentaro, Thinky Corporation), thereby obtaining an epoxy resin composition (solution). The obtained epoxy resin composition (solution) was cured and then measured for the glass-transition temperature, weatherability test, adhesion test, moist-heat-resistant flexibility, and water vapor transmission rate. Table 4 shows the results. In this Comparative Example 12, the test specimen markedly degraded after the weatherability test, and the reflectance thus could not be measured; thus, the YI value could not be determined. The water vapor transmission rate also could not be measured because the test specimen degraded during measurement.

Table 4

| | | | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 | Comparative Example 11 | Comparative Example 12 |
|---|---|---|---|---|---|---|---|---|---|---|---|---|---|---|---|
| Epoxy Resin Composition (Parts by Weight) | Epoxy Resin | jER828 | | 100 | – | – | – | – | – | 100 | 100 | 100 | 100 | 100 | 100 |
| | | YX-8000 | | – | 100 | – | – | – | – | – | – | – | – | – | – |
| | | HBE-100 | | – | – | 100 | – | – | – | – | – | – | – | – | – |
| | | TEPIC-L | | – | – | – | 100 | – | – | – | – | – | – | – | – |
| | | jER152 | | – | – | – | – | 100 | – | – | – | – | – | – | – |
| | | N-660 | | – | – | – | – | – | 100 | – | – | – | – | – | – |
| | Curing Agent | MH-T | | 91 | 83 | 79 | 171 | 97 | 82 | 91 | – | – | – | – | – |
| | | MH-700 | | – | – | – | – | – | – | – | 89 | 89 | – | – | – |
| | | HNA-100 | | – | – | – | – | – | – | – | – | – | 97 | 97 | – |
| | | FXJ-8077 | | – | – | – | – | – | – | – | – | – | – | – | 35 |
| | Cure Accelerator | TBP-BB | | 1 | 1 | 1 | 1 | 1 | 1 | – | 1 | – | 1 | – | – |
| | | PX-4ET | | – | – | – | – | – | – | 1 | – | 1 | – | 1 | – |
| Evaluation of Physical Properties of Cured Epoxy Product | Initial Transparency (YI) | | | 3.2 | 2.8 | 2.5 | 2.3 | 4.6 | 5.8 | 2.8 | 2.7 | 2.6 | 2.8 | 2.8 | 0.22 |
| | Weatherability Test | Weather-yellowing Resistance (ΔYI) | | unmeasurable | unmeasurable | unmeasurable | unmeasurable | unmeasurable | unmeasurable | unmeasurable | unmeasurable | unmeasurable | unmeasurable | unmeasurable | unmeasurable |
| | | Weather-crack Resistance | | B | B | B | B | B | B | B | B | B | B | B | B |
| | Adhesion Test | | Steel Plate | B | B | B | B | B | B | B | B | B | B | B | B |
| | | | PC | B | B | B | B | B | B | B | B | B | B | B | B |
| | | | PET | B | B | B | B | B | B | B | B | B | B | B | B |
| | | | PI | B | B | B | B | B | B | B | B | B | B | B | B |
| | | | Copper Plate | B | B | B | B | B | B | B | B | B | B | B | B |
| | | Adhesion in Boiling Water | PC | B | B | B | B | B | B | B | B | B | B | B | B |
| | | | PET | B | B | B | B | B | B | B | B | B | B | B | B |
| | | | PI | B | B | B | B | B | B | B | B | B | B | B | B |
| | | | Copper Plate | B | B | B | B | B | B | B | B | B | B | B | B |
| | | Moist-heat-resistant Adhesion | PC | B | B | B | B | B | B | B | B | B | B | B | B |
| | | | PET | B | B | B | B | B | B | B | B | B | B | B | B |
| | Moist-heat-resistant Flexibility | PC (bent to 90° angle) | | B | B | B | B | B | B | B | B | B | B | B | B |
| | | PET (bent to 180° angle) | | B | B | B | B | B | B | B | B | B | B | B | B |
| | Glass-transition Temperature (°C) | | | 30 | 26 | 26 | 35 | 33 | 33 | 30 | 28 | 30 | 35 | 35 | 53 |
| | Water Vapor Transmission Rate | | | unmeasurable | unmeasurable | unmeasurable | unmeasurable | unmeasurable | unmeasurable | unmeasurable | unmeasurable | unmeasurable | unmeasurable | unmeasurable | unmeasurable |

Comparative Examples 13 to 19

Epoxy resins, curing agents, and cure accelerators shown in Table 5 were mixed at compositional ratios (parts by weight) shown in Table 5 in the same manner as in Comparative Example 1, thereby obtaining epoxy resin compositions (solution). The obtained epoxy resin compositions (solution) were cured and then measured for the glass-transition temperature, weatherability test, adhesion test, moist-heat-resistant flexibility, and water vapor transmission rate. Table 5 shows the results. In Comparative Example 17, the cure accelerator did not dissolve in the mixture solution of the epoxy resin and the curing agent. In Comparative Examples 18 and 19, the test specimens markedly degraded after the weatherability test, and the reflectance thus could not be measured; thus, the YI values could not be determined. The water vapor transmission rates also could not be measured because the test specimens degraded during measurement.

Table 5

| | | | | Comparative Example 13 | Comparative Example 14 | Comparative Example 15 | Comparative Example 16 | Comparative Example 17 | Comparative Example 18 | Comparative Example 19 |
|---|---|---|---|---|---|---|---|---|---|---|
| Epoxy Resin Composition (Parts by Weight) | Epoxy Resin | HBE-100 | | 100 | 100 | 100 | 100 | 100 | 100 | 100 |
| | Curing Agent | HB/HH | | 530 | 530 | 530 | 530 | 530 | – | – |
| | | MH-700 | | – | – | – | – | – | 76 | – |
| | | HNA-100 | | – | – | – | – | – | – | 83 |
| | Cure Accelerator | TBP-BB | | 1 | – | – | 1 | – | 1 | 1 |
| | | TPP-PB | | – | 1 | – | – | – | – | – |
| | | DBU | | – | – | 1 | – | – | – | – |
| | | DMP-30 | | – | – | – | 1 | – | – | – |
| | | U-CAT5003 | | – | – | – | – | 1 | – | – |
| Evaluation of Physical Properties of Cured Epoxy Product | Initial Transparency (YI) | | | −0. 1 | 0. 03 | 0. 3 | 2. 3 | Not dissolved in the mixture solution | 2. 5 | 2. 5 |
| | Weatherability Test | Weather-yellowing Resistance (ΔYI) | | 0. 8 | 0. 9 | 1. 1 | 1. 9 | | unmeasurable | unmeasurable |
| | | Weather-crack Resistance | | A | A | B | B | | B | B |
| | Adhesion Test | | Steel Plate | A | A | A | A | | B | B |
| | | | PC | A | A | A | A | | B | B |
| | | | PET | A | A | A | A | | B | B |
| | | | PI | A | A | A | A | | B | B |
| | | | Copper Plate | A | A | B | B | | B | B |
| | | Adhesion in Boiling Water | PC | A | A | A | A | | B | B |
| | | | PET | A | A | A | A | | B | B |
| | | | PI | A | A | A | A | | B | B |
| | | | Copper Plate | A | A | B | B | | B | B |
| | | Moist-heat-resistant Adhesion | PC | A | A | A | A | | B | B |
| | | | PET | A | A | A | A | | B | B |
| | | Moist-heat-resistant Flexibility | PC (bent to 90° angle) | A | A | A | A | | B | B |
| | | | PET (bent to 180° angle) | A | A | A | A | | B | B |
| | Glass-transition Temperature (°C) | | | 113 | 116 | 114 | 118 | | 26 | 35 |
| | Water Vapor Transmission Rate | | | 4. 1 | 4. 2 | 4. 2 | 4. 0 | | unmeasurable | unmeasurable |

Tables 2 to 5 show that the cured epoxy resin products of Examples 1 to 25 were excellent in initial transparency, weatherability, and adhesion to substrates, compared with the cured epoxy resin products of Comparative Examples 1 to 19. The cured epoxy resin products of Examples 1 to 25 were also confirmed to have excellent heat resistance and water vapor barrier properties. These results indicate that combining the epoxy resin (A), the polycarboxylic anhydride (B), and the phosphonium compound (C) can form a cured epoxy resin product that exhibits excellent initial transparency and weatherability and excellent adhesion to various substrates.

The cured epoxy resin products of Examples 6 to 25 were also confirmed to be superior in weatherability to the cured epoxy resin products of Examples 1 to 5. These results indicate that the use of a specific epoxy resin for the epoxy resin (A) can form a cured epoxy resin product that exhibits higher weatherability.

Industrial Applicability

The use of the epoxy resin composition of the present invention can form a cured epoxy resin product that exhibits excellent initial transparency and weatherability and also excellent adhesion to various substrates. Additionally, the cured epoxy resin product exhibits excellent heat resistance and water vapor barrier properties. Because the epoxy resin composition of the present invention can form a cured epoxy resin product with such excellent properties, the composition has wide industrial applications. In particular, the composition can be suitably used in materials for adhesives, coating agents, glazing materials for automobiles, and the like.

## Claims

1. An epoxy resin composition comprising

(A) an epoxy resin;
(B) a polycarboxylic anhydride containing a structural unit represented by formula (1)

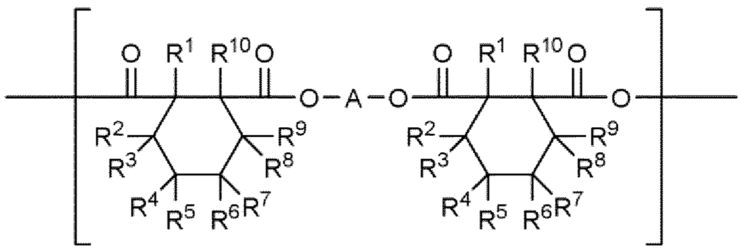
(1)

wherein A represents a cycloalkylene group or a group in which two or more cycloalkylene groups are bonded via a single bond or a divalent group, the cycloalkylene group or the two or more cycloalkylene groups being optionally substituted;
$R^1$ to $R^{10}$ are identical or different and each represent a hydrogen atom or an optionally substituted $C_{1-10}$ alkyl group, and two groups of $R^1$ to $R^{10}$ may be taken together to form a divalent group; and

(C) a phosphonium compound represented by formula (2)

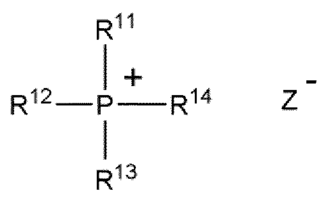
(2)

wherein $R^{11}$ to $R^{14}$ are identical or different and each represent a $C_{1-18}$ alkyl group or an optionally substituted aryl group, and $Z^-$ represents an organic anion.

2. The epoxy resin composition according to claim 1, wherein the epoxy resin (A) is at least one member selected from the group consisting of bisphenol-type epoxy resins, phenol novolac-type epoxy resins, glycidyl ester-type epoxy resins, glycidyl ether-type epoxy resins, amine-type epoxy resins, alicyclic epoxy resins, alicyclic glycidyl

ether-type epoxy resins, triazine-type epoxy resins, and glycoluril-type epoxy resins.

**3.** The epoxy resin composition according to claim 1 or 2, wherein the epoxy resin (A) is at least one member selected from the group consisting of alicyclic glycidyl ether-type epoxy resins, triazine-type epoxy resins, and glycoluril-type epoxy resins.

**4.** The epoxy resin composition according to any one of claims 1 to 3, wherein A in formula (1) is a divalent group represented by formula (3)

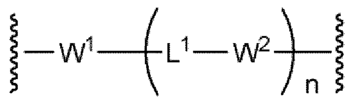

(3)

wherein $W^1$ and $W^2$ are identical or different and represent an optionally substituted $C_{3-30}$ cycloalkylene group; $L^1$ represents a single bond, an optionally substituted $C_{1-10}$ alkylene group, an optionally substituted $C_{3-30}$ cycloalkylene group, an optionally substituted $C_{3-30}$ cycloalkylidene group,-O-, -S-, -CO-, -SO-, or $-SO_2-$; n represents an integer of 0 or 1; and wavy lines represent an attachment site.

**5.** The epoxy resin composition according to claim 4, wherein $W^1$ and $W^2$ in formula (3) are identical or different, and $W^1$ and $W^2$ represent

a divalent group represented by formula (a)

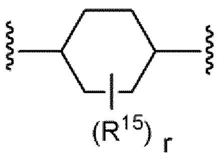

(a)

wherein $R^{15}$ represents an optionally substituted $C_{1-10}$ alkyl group or an optionally substituted $C_{3-30}$ cycloalkyl group; r represents an integer of 0 to 8, and when r represents 2 to 8, two to eight $R^{15}$ groups may be identical or different, and when r represents 2 to 8, two $R^{15}$ groups may be taken together to form a divalent group; and wavy lines represent an attachment site, or
a divalent group represented by formula (b)

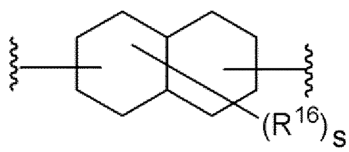

(b)

wherein $R^{16}$ represents an optionally substituted $C_{1-10}$ alkyl group or an optionally substituted $C_{3-30}$ cycloalkyl group; s represents an integer of 0 to 12, and when s represents 2 to 12, two to twelve $R^{16}$ groups may be identical or different, and when s represents 2 to 12, two $R^{16}$ groups may be taken together to form a divalent group; and wavy lines represent an attachment site.

**6.** The epoxy resin composition according to any one of claims 1 to 3, wherein the polycarboxylic anhydride (B) is represented by formula (4)

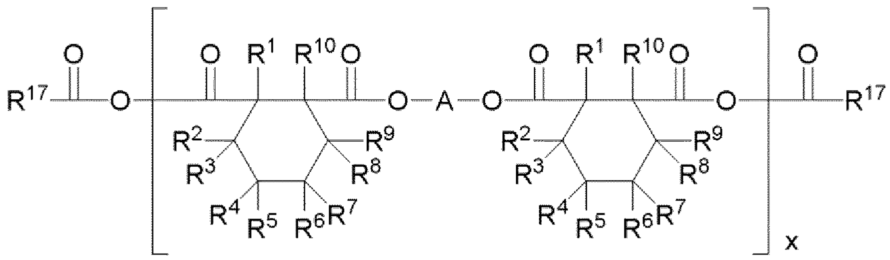

(4)

wherein A and $R^1$ to $R^{10}$ are as defined in formula (1); $R^{17}$ represents an optionally substituted $C_{1-10}$ alkyl group or an optionally substituted $C_{3-30}$ cycloalkyl group; and x represents an integer of 2 or more.

**7.** The epoxy resin composition according to any one of claims 1 to 6, wherein the organic anion ($Z^-$) in formula (2) has a structure represented by formula (5)

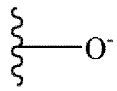

(5)

wherein a wavy line represents an attachment site,
formula (6)

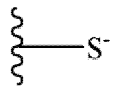

(6)

wherein a wavy line represents an attachment site,
formula (7)

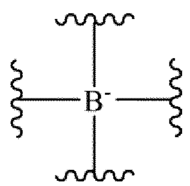

(7)

wherein wavy lines represent an attachment site, or formula (8)

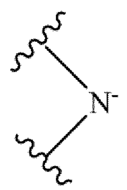

(8)

wherein wavy lines represent an attachment site.

**8.** The epoxy resin composition according to any one of claims 1 to 7, wherein the organic anion ($Z^-$) in formula (2) is at least one member selected from the group consisting of
aliphatic monocarboxylic acid anions represented by formula (9)

$R^{18}COO^-$ (9)

wherein $R^{18}$ represents a $C_{1-17}$ alkyl group,

alicyclic dicarboxylic acid anions represented by formula (10)

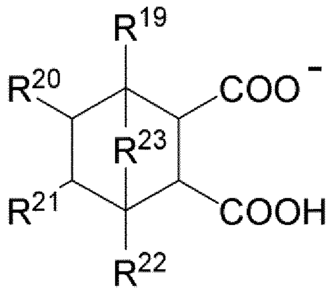

(10)

wherein $R^{19}$ to $R^{22}$ are identical or different and each represent a hydrogen atom or a $C_{1-4}$ alkyl group; and $R^{23}$ represents a methylene group or an ethylene group,
cyclohexane dicarboxylic acid anions represented by formula (11)

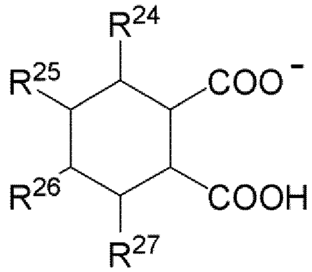

(11)

wherein $R^{24}$ to $R^{27}$ are identical or different and each represent a hydrogen atom or a $C_{1-4}$ alkyl group,
organic sulfonic acid anions represented by formula (12)

$$R^{28}\text{-}SO_3^- \qquad (12)$$

wherein $R^{28}$ represents a $C_{1-18}$ alkyl group,
aromatic sulfonic acid anions represented by formula (13):

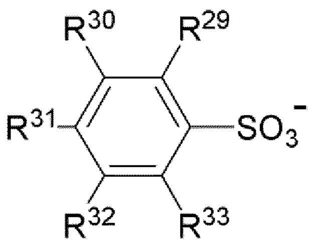

(13)

wherein $R^{29}$ to $R^{33}$ are identical or different and each represent a hydrogen atom, a $C_{1-18}$ alkyl group, a $C_{1-10}$ alkoxy group, or a halogen atom,
organophosphorus anions represented by formula (14)

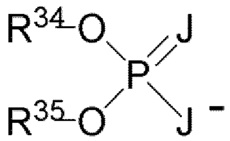

(14)

wherein $R^{34}$ and $R^{35}$ are identical or different and each represent a $C_{1-18}$ alkyl group; and J represents an oxygen atom or a sulfur atom,
aromatic boron anions represented by formula (15)

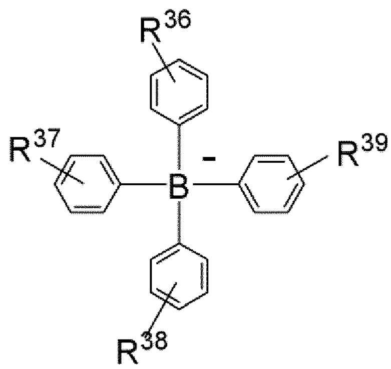

(15)

wherein $R^{36}$ to $R^{39}$ are identical or different and each represent a hydrogen atom, a $C_{1-18}$ alkyl group, a $C_{1-10}$ alkoxy group, or a halogen atom, and
benzotriazole anions represented by formula (16)

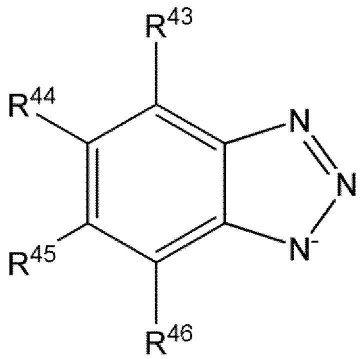

(16)

wherein $R^{43}$ to $R^{46}$ are identical or different and each represent a hydrogen atom or a $C_{1-4}$ alkyl group.

**9.** An adhesive material or coating material comprising the epoxy resin composition of any one of claims 1 to 8.

**10.** An automotive glazing material comprising the epoxy resin composition of any one of claims 1 to 8.

**11.** An epoxy resin molded article formed by curing the epoxy resin composition according to any one of claims 1 to 8.

**12.** A method for forming a thin film comprising

applying the epoxy resin composition of any one of claims 1 to 8 onto a substrate, and
curing the coated film to form a thin film with a thickness of 1 mm or less.

**13.** A thin film with a thickness of 1 mm or less formed by curing the epoxy resin composition of any one of claims 1 to 8.

**14.** The thin film according to claim 13, which is a coating material for displays.

**Patentansprüche**

**1.** Eine Epoxidharzzusammensetzung umfassend

(A) ein Epoxidharz;
(B) ein Polycarbonsäureanhydrid, das eine Struktureinheit dargestellt durch Formel (1) enthält

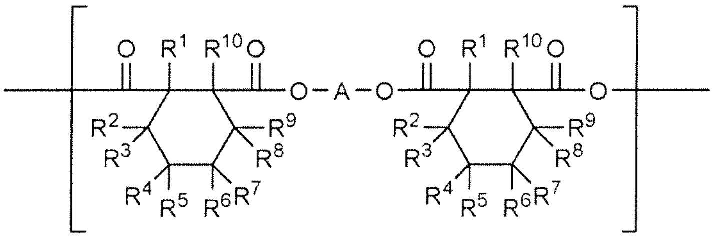

(1)

wobei A für eine Cycloalkylengruppe oder eine Gruppe in der zwei oder mehr Cycloalkylengruppen über eine Einfachbindung oder eine divalente Gruppe gebunden sind steht, wobei die Cycloalkylengruppe oder die zwei oder mehr Cycloalkylengruppen gegebenenfalls substituiert sind;
$R^1$ bis $R^{10}$ gleich oder verschieden sind und jeweils ein Wasserstoffatom oder eine gegebenenfalls substituierte $C_{1-10}$ Alkylgruppe darstellen, und zwei Gruppen von $R^1$ bis $R^{10}$ zusammen genommen werden können, um eine divalente Gruppe zu bilden; und

(C) eine Phosphoniumverbindung dargestellt durch Formel (2)

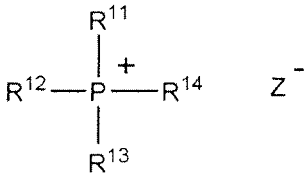

(2)

wobei $R^{11}$ bis $R^{14}$ gleich oder verschieden sind und jeweils eine $C_{1-18}$ Alkylgruppe oder eine gegebenenfalls substituierte Arylgruppe darstellen, und $Z^-$ ein organisches Anion darstellt.

**2.** Die Epoxidharzzusammensetzung gemäß Anspruch 1, wobei das Epoxidharz (A) mindestens ein Element ist, ausgewählt aus der Gruppe bestehend aus Epoxidharzen vom Bisphenol-Typ, Epoxidharzen vom Phenol-Novolac-Typ, Epoxidharzen vom Glycidylester-Typ, Epoxidharzen vom Glycidylether-Typ, Epoxidharzen vom Amin-Typ, alicyclischen Epoxidharzen, alicyclischen Epoxidharzen vom Glycidylether-Typ, Epoxidharzen vom Triazin-Typ und Epoxidharzen vom Glycoluril-Typ.

**3.** Die Epoxidharzzusammensetzung gemäß Anspruch 1 oder 2, wobei das Epoxidharz (A) mindestens ein Element ist, ausgewählt aus der Gruppe bestehend aus alicyclischen Epoxidharzen vom Glycidylether-Typ, Epoxidharzen vom Triazin-Typ und Epoxidharzen vom Glycoluril-Typ.

**4.** Die Epoxidharzzusammensetzung gemäß einem der Ansprüche 1 bis 3, wobei A in Formel (1) eine divalente Gruppe ist, dargestellt durch Formel (3)

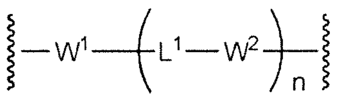

(3)

wobei $W^1$ und $W^2$ gleich oder verschieden sind und eine gegebenenfalls substituierte $C_{3-30}$ Cycloalkylengruppe darstellen; $L^1$ eine Einfachbindung, eine gegebenenfalls substituierte $C_{1-10}$ Alkylengruppe, eine gegebenenfalls substituierte $C_{3-30}$ Cycloalkylengruppe, eine gegebenenfalls substituierte $C_{3-30}$ Cycloalkylidengruppe, -O-, -S-, -CO-, -SO-, oder $-SO_2$-darstellt; n eine ganze Zahl von 0 oder 1 darstellt; und gewellte Linien eine Verknüpfungsstelle darstellen.

**5.** Die Epoxidharzzusammensetzung gemäß Anspruch 4, wobei $W^1$ und $W^2$ in Formel (3) gleich oder verschieden sind, und
$W^1$ und $W^2$ eine divalente Gruppe darstellen, dargestellt durch Formel (a)

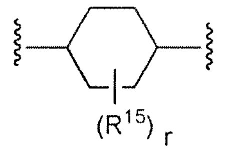

(a)

wobei $R^{15}$ eine gegebenenfalls substituierte $C_{1-10}$ Alkylgruppe oder eine gegebenenfalls substituierte $C_{3-30}$ Cycloalkylgruppe darstellt; r eine ganze Zahl von 0 bis 8 darstellt, und wenn r 2 bis 8 darstellt, zwei bis acht $R^{15}$ Gruppen gleich oder verschieden sein können, und wenn r 2 bis 8 darstellt, zwei $R^{15}$ Gruppen zusammen genommen werden können, um eine divalente Gruppe zu bilden; und gewellte Linien eine Verknüpfungsstelle darstellen, oder eine divalente Gruppe darstellen, dargestellt durch Formel (b)

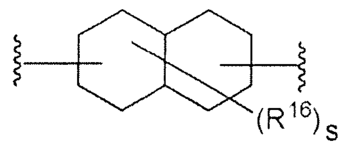

(b)

wobei $R^{16}$ eine gegebenenfalls substituierte $C_{1-10}$ Alkylgruppe oder eine gegebenenfalls substituierte $C_{3-30}$ Cycloalkylgruppe darstellt; s eine ganze Zahl von 0 bis 12 darstellt, und wenn s 2 bis 12 darstellt, zwei bis zwölf $R^{16}$ Gruppen gleich oder verschieden sein können, und wenn s 2 bis 12 darstellt, zwei $R^{16}$ Gruppen zusammen genommen werden können, um eine divalente Gruppe zu bilden; und gewellte Linien eine Verknüpfungsstelle darstellen.

**6.** Die Epoxidharzzusammensetzung gemäß einem der Ansprüche 1 bis 3, wobei das Polycarbonsäureanhydrid (B) durch Formel (4) dargestellt wird

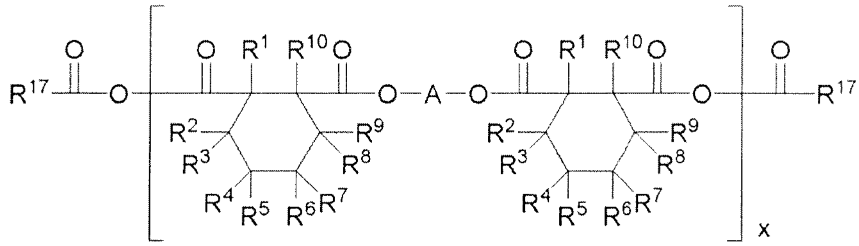

(4)

wobei A und $R^1$ bis $R^{10}$ wie in Formel (1) definiert sind; $R^{17}$ eine gegebenenfalls substituierte $C_{1-10}$ Alkylgruppe oder eine gegebenenfalls substituierte $C_{3-30}$ Cycloalkylgruppe darstellt; und x eine ganze Zahl von 2 oder mehr darstellt.

**7.** Die Epoxidharzzusammensetzung gemäß einem der Ansprüche 1 bis 6, wobei das organische Anion ($Z^-$) in Formel (2) eine Struktur aufweist, dargestellt durch Formel (5)

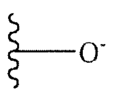

(5)

wobei eine gewellte Linie eine Verknüpfungsstelle darstellt,
Formel (6)

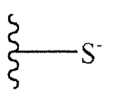

(6)

wobei eine gewellte Linie eine Verknüpfungsstelle darstellt,
Formel (7)

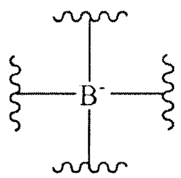

(7)

wobei gewellte Linien eine Verknüpfungsstelle darstellen, oder
Formel (8)

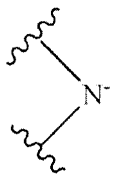

(8)

wobei gewellte Linien eine Verknüpfungsstelle darstellen.

**8.** Die Epoxidharzzusammensetzung gemäß einem der Ansprüche 1 bis 7, wobei das organische Anion ($Z^-$) in Formel (2) mindestens ein Element ist, ausgewählt aus der Gruppe bestehend aus
aliphatischen Monocarbonsäureanionen der Formel (9)

$R^{18}COO^-$ (9)

wobei $R^{18}$ eine $C_{1-17}$ Alkylgruppe darstellt,

alicyclischen Dicarbonsäureanionen, dargestellt durch Formel (10)

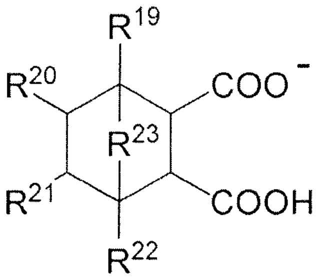

(10)

wobei $R^{19}$ bis $R^{22}$ gleich oder verschieden sind und jeweils ein Wasserstoffatom oder eine $C_{1-4}$ Alkylgruppe darstellen; und $R^{23}$ eine Methylengruppe oder eine Ethylengruppe darstellt,
Cyclohexandicarbonsäureanionen, dargestellt durch Formel (11)

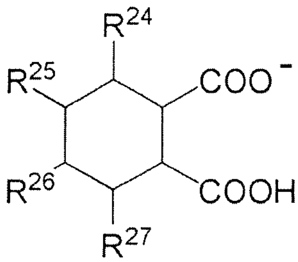

(11)

wobei $R^{24}$ bis $R^{27}$ gleich oder verschieden sind und jeweils ein Wasserstoffatom oder eine $C_{1-4}$ Alkylgruppe darstellen,
organischen Sulfonsäureanionen, dargestellt durch Formel (12)

$R^{28}\text{-}SO_3^-$ (12)

wobei $R^{28}$ eine $C_{1-18}$ Alkylgruppe darstellt, aromatische Sulfonsäureanionen der Formel (13):

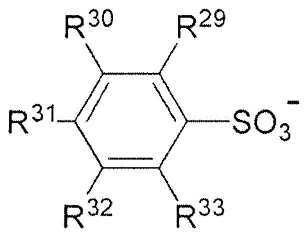

(13)

wobei $R^{29}$ bis $R^{33}$ gleich oder verschieden sind und jeweils ein Wasserstoffatom, eine $C_{1-18}$ Alkylgruppe, eine $C_{1-10}$ Alkoxygruppe oder ein Halogenatom darstellen, Organophosphoranionen, dargestellt durch Formel (14)

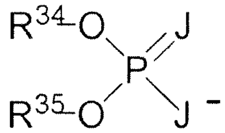

(14)

wobei $R^{34}$ und $R^{35}$ gleich oder verschieden sind und jeweils eine $C_{1-18}$ Alkylgruppe darstellen; und J ein Sauerstoffatom oder ein Schwefelatom darstellt, aromatischen Boranionen, dargestellt durch Formel (15)

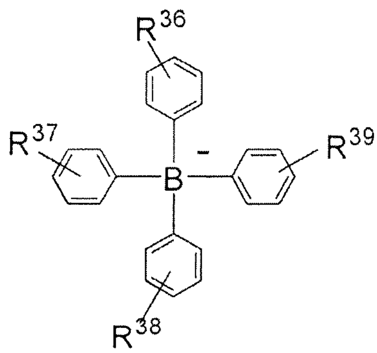

(15)

wobei $R^{36}$ bis $R^{39}$ gleich oder verschieden sind und jeweils ein Wasserstoffatom, eine $C_{1-18}$ Alkylgruppe, eine $C_{1-10}$ Alkoxygruppe, oder ein Halogenatom darstellen, und Benztriazolanionen, dargestellt durch Formel (16)

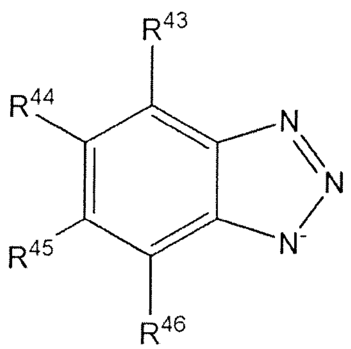

(16)

wobei $R^{43}$ bis $R^{46}$ gleich oder verschieden sind und jeweils ein Wasserstoffatom oder eine $C_{1-4}$ Alkylgruppe darstellen.

9. Ein Klebstoffmaterial oder Beschichtungsmaterial, umfassend die Epoxidharzzusammensetzung nach einem der Ansprüche 1 bis 8.

10. Ein Automobilverscheibungsmaterial, umfassend die Epoxidharzzusammensetzung nach einem der Ansprüche 1 bis 8.

11. Ein Epoxidharz-Formgegenstand, der durch Härten der Epoxidharzzusammensetzung gemäß einem der Ansprüche 1 bis 8 gebildet ist.

12. Ein Verfahren zum Bilden eines dünnen Films, umfassend
Aufbringen der Epoxidharzzusammensetzung nach einem der Ansprüche 1 bis 8 auf ein Substrat, und
Härten des Beschichtungsfilms um einen dünnen Film mit einer Dicke von 1 mm oder weniger zu erhalten.

13. Ein dünner Film mit einer Dicke von 1 mm oder weniger, der durch Härten der Epoxidharzzusammensetzung nach einem der Ansprüche 1 bis 8 gebildet ist.

14. Der dünne Film gemäß Anspruch 13, der ein Beschichtungsmaterial für Anzeigevorrichtungen ist.

## Revendications

1. Composition de résine époxy comprenant

(A) une résine époxy;
(B) un anhydride polycarboxylique contenant une unité structurelle représentée par la formule (1)

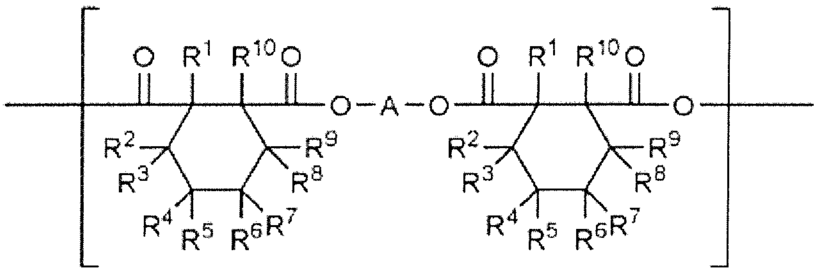

(1)

dans laquelle A représente un groupe cycloalkylène ou un groupe dans lequel deux groupes cycloalkylène ou plus sont liés via une liaison simple ou un groupe divalent, le groupe cycloalkylène ou les deux groupes cycloalkylène ou plus étant éventuellement substitués;
$R^1$ à $R^{10}$ sont identiques ou différents et représentent chacun un atome d'hydrogène ou un groupe alkyle en $C_{1-10}$ éventuellement substitué, et deux groupes de $R^1$ à $R^{10}$ peuvent être pris ensemble pour former un groupe divalent; et

(C) un composé de phosphonium représenté par la formule (2)

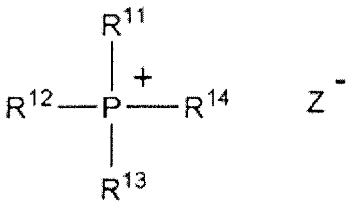

(2)

dans laquelle $R^{11}$ à $R^{14}$ sont identiques ou différents et représentent chacun un groupe alkyle en $C_{1-18}$ ou un groupe aryle éventuellement substitué, et $Z^-$ représente un anion organique.

2. Composition de résine époxy selon la revendication 1, dans laquelle la résine époxy (A) est au moins un élément choisi dans le groupe consistant en résines époxy de type bisphénol, résines époxy de type phénol novolaque,

résines époxy de type ester glycidylique, résines époxy de type glycidyléther, résines époxy de type amine, résines époxy alicycliques, résines époxy de type glycidyléther alicycliques, résines époxy de type triazine, et résines époxy de type glycolurile.

**3.** Composition de résine époxy selon la revendication 1 ou 2, dans laquelle la résine époxy (A) est au moins un élément choisi dans le groupe consistant en résines époxy de type glycidyléther alicycliques, résines époxy de type triazine, et résines époxy de type glycolurile.

**4.** Composition de résine époxy selon l'une quelconque des revendications 1 à 3, dans laquelle A dans la formule (1) est un groupe divalent représenté par la formule (3)

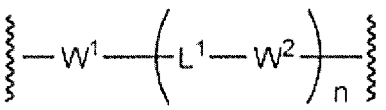

(3)

dans laquelle $W^1$ et $W^2$ sont identiques ou différents et représentent un groupe cycloalkylène en $C_{3-30}$ éventuellement substitué; $L^1$ représente une liaison simple, un groupe alkylène en $C_{1-10}$ éventuellement substitué, un groupe cycloalkylène en $C_{3-30}$ éventuellement substitué, un groupe cycloalkylidène en $C_{3-30}$ éventuellement substitué, -O-, -S-, -CO-, -SO-, ou $-SO_2-$; n représente un nombre entier de 0 ou 1; et les lignes ondulées représentent un site de fixation.

**5.** Composition de résine époxy selon la revendication 4, dans laquelle $W^1$ et $W^2$ dans la formule (3) sont identiques ou différents, et $W^1$ et $W^2$ représentent un groupe divalent représenté par la formule (a)

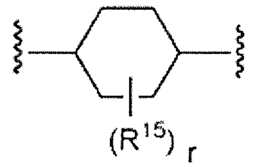

(a)

dans laquelle $R^{15}$ représente un groupe alkyle en $C_{1-10}$ éventuellement substitué ou un groupe cycloalkyle en $C_{3-30}$ éventuellement substitué; r représente un nombre entier de 0 à 8, et lorsque r représente de 2 à 8, deux à huit groupes $R^{15}$ peuvent être identiques ou différents, et lorsque r représente 2 à 8, deux groupes $R^{15}$ peuvent être pris ensemble pour former un groupe divalent; et des lignes ondulées représentent un site de fixation, ou
un groupe divalent représenté par la formule (b)

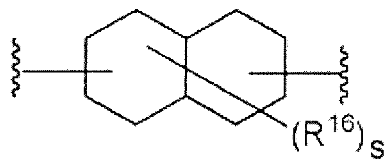

(b)

dans laquelle $R^{16}$ représente un groupe alkyle en $C_{1-10}$ éventuellement substitué ou un groupe cycloalkyle en $C_{3-30}$ éventuellement substitué; s représente un nombre entier de 0 à 12, et lorsque s représente de 2 à 12, deux à douze groupes $R^{15}$ peuvent être identiques ou différents, et lorsque s représente 2 à 12, deux groupes $R^{16}$ peuvent être pris ensemble pour former un groupe divalent; et des lignes ondulées représentent un site de fixation.

**6.** Composition de résine époxy selon l'une quelconque des revendications 1 à 3, dans laquelle l'anhydride polycarboxylique (B) est représenté par la formule (4)

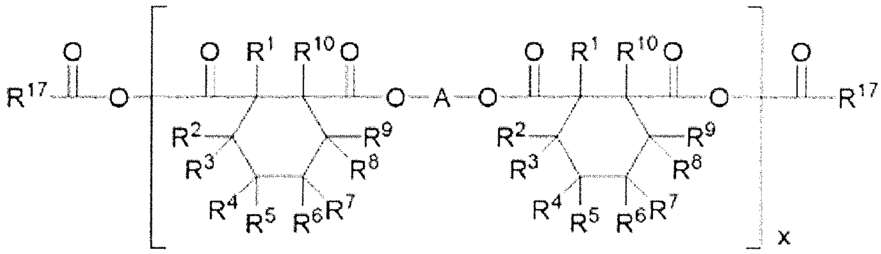

(4)

dans laquelle A et $R^1$ à $R^{10}$ sont comme définis dans la formule (1); $R^{17}$ représente un groupe alkyle en $C_{1-10}$ éventuellement substitué ou un groupe cycloalkyle en $C_{3-30}$ éventuellement substitué; et x représente un nombre entier de 2 ou supérieur.

7. Composition de résine époxy selon l'une quelconque des revendications 1 à 6, dans laquelle l'anion organique ($Z^-$) dans la formule (2) présente une structure représentée par la formule (5)

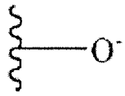

(5)

dans laquelle une ligne ondulée représente un site de fixation, formule (6)

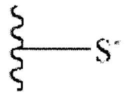

(6)

dans laquelle une ligne ondulée représente un site de fixation, formule (7)

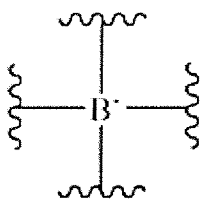

(7)

dans laquelle des lignes ondulées représentent un site de fixation, ou formule (8)

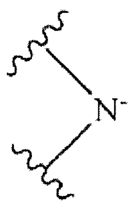

(8)

dans laquelle des lignes ondulées représentent un site de fixation.

8. Composition de résine époxy selon l'une quelconque des revendications 1 à 7, dans laquelle l'anion organique ($Z^-$) dans la formule (2) est au moins un élément choisi dans le groupe consistant en anions d'acide monocarboxylique aliphatique représentés par la formule (9)

$$R^{18}COO^- \quad (9)$$

dans laquelle $R^{18}$ représente un groupe alkyle en $C_{1-17}$,

anions d'acide dicarboxylique alicyclique représentés par la formule (10)

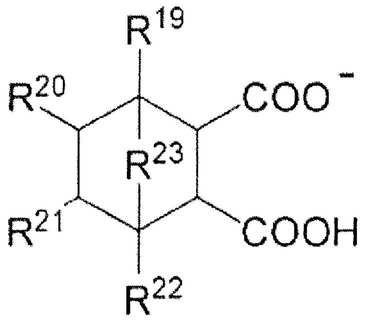

(10)

dans laquelle $R^{19}$ à $R^{22}$ sont identiques ou différents et représentent chacun un atome d'hydrogène ou un groupe alkyle en $C_{1-4}$; et $R^{23}$ représente un groupe méthylène ou un groupe éthylène,
anions d'acide cyclohexanedicarboxylique représenté par la formule (11)

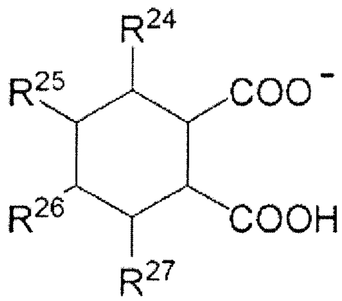

(11)

dans laquelle $R^{24}$ à $R^{27}$ sont identiques ou différents et représentent chacun un atome d'hydrogène ou un groupe alkyle en $C_{1-4}$,
anions d'acide sulfonique organique représentés par la formule (12)

$$R^{28}\text{-}SO_3^- \qquad (12)$$

dans laquelle $R^{28}$ représente un groupe alkyle en $C_{1-18}$,
anions d'acide sulfonique aromatique représentés par la formule (13) :

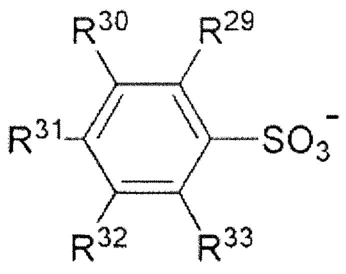

(13)

dans laquelle $R^{29}$ à $R^{33}$ sont identiques ou différents et représentent chacun un atome d'hydrogène, un groupe alkyle en $C_{1-18}$, un groupe alcoxy en $C_{1-10}$, ou un atome d'halogène,
anions d'organophosphore représentés par la formule (14)

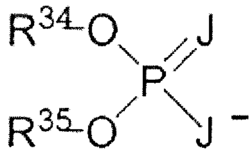

(14)

dans laquelle $R^{34}$ et $R^{35}$ sont identiques ou différents et représentent chacun un groupe alkyle en $C_{1-18}$; et J représente un atome d'oxygène ou un atome de soufre,
anions de bore aromatiques représentés par la formule (15)

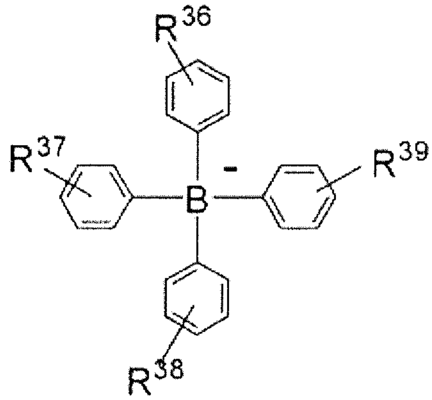

(15)

dans laquelle $R^{36}$ à $R^{39}$ sont identiques ou différents et représentent chacun un atome d'hydrogène, un groupe alkyle en $C_{1-18}$, un groupe alcoxy en $C_{1-10}$, ou un atome d'halogène, et
anions de benzotriazole représentés par la formule (16)

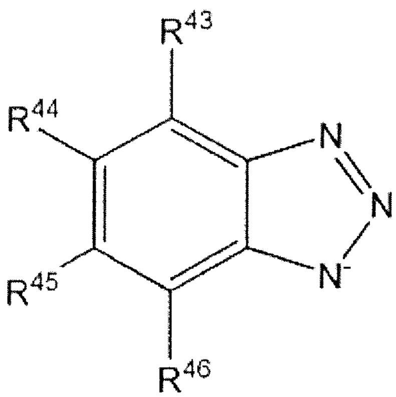

(16)

dans laquelle $R^{43}$ à $R^{46}$ sont identiques ou différents et représentent chacun un atome d'hydrogène ou un groupe alkyle en $C_{1-4}$.

**9.** Matériau adhésif ou matériau de revêtement comprenant la composition de résine époxy selon l'une quelconque des revendications 1 à 8.

**10.** Matériau de vitrage d'automobile comprenant la composition de résine époxy selon l'une quelconque des revendications 1 à 8.

**11.** Article moulé en résine époxy formé par durcissement de la composition de résine époxy selon l'une quelconque des revendications 1 à 8.

**12.** Procédé pour la formation d'un film mince comprenant

l'application de la composition de résine époxy selon l'une quelconque des revendications 1 à 8 sur un substrat, et le durcissement du film déposé pour former un film mince avec une épaisseur de 1 mm ou inférieure.

**13.** Film mince avec une épaisseur de 1 mm ou inférieure formé par durcissement de la composition de résine époxy selon l'une quelconque des revendications 1 à 8.

**14.** Film mince selon la revendication 13, lequel est un matériau de revêtement pour affichages.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2014171529 A1
- JP 2003002951 A
- JP H11158251 A
- JP H07196774 A
- JP 2012132028 A
- JP S56122840 A
- JP H09302268 A
- JP 2008179733 A
- JP 2010106131 A